# EUROPEAN PATENT APPLICATION

(11) **EP 4 583 172 A1**
(43) Date of publication of application: **09.07.2025**
(21) Application number: 23860739.4
(22) Date of filing: 17.08.2023
(51) Int. Cl.: H01L 33/50, H01L 25/075, H01L 27/15, H01L 33/62, H01L 33/38, H01L 33/08, H01L 33/56, H01L 33/48

(54) **PIXEL ELEMENT, AND DISPLAY DEVICE COMPRISING SAME**

(30) Priority: 31.08.2022 US 202263402908 P; 12.04.2023 US 202363458919 P; 25.04.2023 US 202318139285; 10.08.2023 US 202318232652
(71) Applicant: Seoul Viosys Co., Ltd., Ansan-si, Gyeonggi-do 15429 (KR)
(72) Inventor: LEE, Chung Hoon, Ansan-si Gyeonggi-do 15429 (KR); JANG, Jong Min, Ansan-si Gyeonggi-do 15429 (KR)
(74) Representative: Stolmár & Partner Patentanwälte PartG mbB
(86) International application number: PCT/KR2023/012136
(87) International publication number: WO 2024/049061

(57) **Abstract**

A pixel device includes a first light emitting device; a second light emitting device horizontally disposed adjacent to the first light emitting device; a first cover layer covering the first light emitting device and the second light emitting device; and connection layers disposed on the first cover layer and electrically connected to the first and second light emitting devices, wherein the first light emitting device includes a first light emitting structure, and the second light emitting device includes a second light emitting structure and a third light emitting structure, the first light emitting structure emitting light having a longer peak wavelength than peak wavelengths of light emitted from the second and third light emitting structures, the second and third light emitting structures emitting light having different peak wavelengths.

## Description

### [Technical Field]

Embodiments of the present disclosure relate to a pixel device and a display apparatus including the same, and more particularly, to a pixel device capable of emitting various colors of light and a display apparatus including the same.

### [Background Art]

Light emitting devices are semiconductor devices that use light emitting diodes as an inorganic light source and are widely used in various fields, such as displays, vehicular lamps, and general lighting. The light emitting diodes have various advantages, such as long lifespan, low power consumption, and fast response, and are rapidly replacing traditional light sources.

Although the light emitting diodes have been generally used as a light source of a backlight unit in a typical display, displays capable of directly implementing images using the light emitting diodes have been developed in recent years. These displays are sometimes referred to as micro-LED displays.

In general, a display apparatus implements a variety of colors using a mixture of blue, green, and red. To implement various images, the display apparatus includes a plurality of pixels, each of which includes blue, green and red subpixels. A color of a certain pixel is determined through colors of these subpixels and an image is implemented through combination of these pixels.

In a micro-LED display, micro-LEDs are arranged corresponding to each subpixel on a plane and a large number of micro-LEDs is mounted on a single substrate. However, since the micro-LEDs are as small as 200 *µ*m or less and even 100 *µ*m or less, it is difficult to transfer all micro-LEDs to a single circuit board. To reduce the number of micro-LEDs, pixel modules with blue, green, and red light emitting devices stacked vertically one above another may be used. However, these pixel modules have a disadvantage of relatively low intensity of red light.

### [Disclosure]

### [Technical Problem]

Embodiments of the present disclosure provide a novel pixel device capable of reducing the number of micro-LEDs mounted thereon without decrease in intensity of red light and a display apparatus including the same.

Embodiments of the present disclosure provide a novel pixel device capable of further increasing the intensity of red light and a display apparatus including the same.

### [Technical Solution]

In accordance with one exemplary embodiment, a pixel device includes: a first light emitting device; a second light emitting device horizontally disposed adjacent to the first light emitting device; a first cover layer covering the first light emitting device and the second light emitting device; and connection layers disposed on the first cover layer and electrically connected to the first and second light emitting devices, wherein the first light emitting device includes a first light emitting structure, and the second light emitting device includes a second light emitting structure and a third light emitting structure, the first light emitting structure emitting light having a longer peak wavelength than peak wavelengths of light emitted from the second and third light emitting structures, the second and third light emitting structures emitting light having different peak wavelengths.

The first light emitting structure may include an arsenide or phosphide-based semiconductor layer and the second and third light emitting structures may include a nitride-based semiconductor layer.

The second light emitting structure and the third light emitting structure may be stacked in a vertical direction.

The pixel device may further include a bonding layer bonding the second light emitting structure to the third light emitting structure.

Each of the second light emitting structure and the third light emitting structure may include a first conductivity type semiconductor layer, an active layer, and a second conductivity type semiconductor layer, the first conductivity type semiconductor layers of the second and third light emitting structures may be electrically connected to each other, and the second conductivity type semiconductor layers of the second and third light emitting structures may be electrically insulated from one another.

The second light emitting device may include an electrode pad electrically connecting the first conductivity type semiconductor layers of the second and third light emitting structures to each other and one of the connection layers may be electrically connected to the electrode pad.

The second light emitting device may include electrode pads electrically connected to the first conductivity type semiconductor layers of the second and third light emitting structures, respectively, and one of the connection layers may be connected to the electrode pads to electrically connect the electrode pads to each other.

The third light emitting structure may be disposed on the second light emitting structure and may emit light having a shorter wavelength than the second light emitting structure.

The pixel device may further include a substrate, the first and second light emitting devices may be disposed on the substrate, and an upper surface of the substrate facing the first and second light emitting devices may include a roughness pattern.

Lower surfaces of the first and second light emitting devices facing the substrate may have a roughness pattern.

The pixel device may further include a second cover layer covering the first cover layer and the connection layers, and the second cover layer may be disposed to partially expose the connection layers.

The second cover layer may be formed of the same material as the first cover layer.

The first and second cover layers may be formed of polyimide.

The second cover layer may partially cover edges of the connection layers.

The first light emitting device may further include a sub-light emitting structure in addition to the first light emitting structure, and the sub-light emitting structure may emit light having a longer peak wavelength than light emitted from the second and third light emitting structures.

The first light emitting structure may be bonded to the sub-light emitting structure via a tunnel layer.

The first light emitting structure and the sub-light emitting structure may emit the same color of light.

In accordance with another exemplary embodiment, a display apparatus includes: a circuit substrate; and a pixel device disposed on the circuit substrate, wherein the pixel device may be the pixel device described above.

In accordance with one exemplary embodiment, a light emitting diode may include: a first light emitting stack, a second light emitting stack disposed on the first light emitting stack, a third light emitting stack disposed the second light emitting stack, and a bonding layer bonding the first light emitting stack to the second light emitting stack. At least some fraction of light emitted from the second light emitting stack may be emitted through a region of the bonding layer formed on a side surface of the first light emitting stack and an upper surface of the second light emitting stack. In addition, the first light emitting stack may include a region at least partially not overlapping the third light emitting stack and may at least partially overlap the second light emitting stack in top view of the first light emitting stack. In addition, the first light emitting stack may be disposed at an outer periphery to surround the second light emitting stack and the third light emitting stack, and the second light emitting stack and the third light emitting stack may be disposed to pass through a center of the light emitting diode.

### [Description of Drawings]

FIG. 1A is a schematic plan view of a display apparatus according to an exemplary embodiment.
FIG. 1B is a schematic perspective view of a display apparatus according to another exemplary embodiment.
FIG. 1C is a schematic perspective view of a display apparatus according to a further exemplary embodiment.
FIG. 1D is a schematic perspective view of a display apparatus according to yet another exemplary embodiment.
FIG. 2A is a schematic plan view of a pixel device according to an exemplary embodiment.
FIG. 2B is a cross-sectional view taken along line A-A' of FIG. 2A.
FIG. 2C is a cross-sectional view taken along line B-B' of FIG. 2A.
FIG. 3A is a schematic plan view of a first light emitting device according to an exemplary embodiment.
FIG. 3B is a cross-sectional view taken along line C-C' of FIG. 3A.
FIG. 4A is a schematic plan view of a second light emitting device according to an exemplary embodiment.
FIG. 4B is a cross-sectional view taken along line D-D' of FIG. 4A.
FIG. 5 is a schematic cross-sectional view of a second light emitting device according to another exemplary embodiment.
FIG. 6 is a schematic cross-sectional view of a pixel device according to another exemplary embodiment.
FIG. 7 is a schematic cross-sectional view of a first light emitting device according to another exemplary embodiment.
FIG. 8 is a schematic cross-sectional view of the pixel device according to another exemplary embodiment.
FIG. 9 is a schematic plan view of a pixel device according to a further exemplary embodiment.
FIG. 10A is a view of a stack type semiconductor layer according to an exemplary embodiment.
FIG. 10B is a view of a stack type semiconductor layer according to an exemplary embodiment before the stack type semiconductor layer shown in FIG. 10A is formed.
FIG. 11A is a view illustrating a method of manufacturing a first light emitting stack of a stack type semiconductor layer according to an exemplary embodiment.
FIG. 11B is a view illustrating the method of manufacturing the first light emitting stack of the stack type semiconductor layer according to the exemplary embodiment.
FIG. 12 is a view illustrating the method of manufacturing the first light emitting stack and a substrate of the stack type semiconductor layer according to the exemplary embodiment.
FIG. 13 is a view illustrating the method of manufacturing the first light emitting stack and the substrate of the stack type semiconductor layer according to the exemplary embodiment.
FIG. 14A is a cross-sectional view taken along line E-E' of FIG. 14B.
FIG. 14B is a plan view obtained from FIG. 14A and FIG. 15.
FIG. 15 is a cross-sectional view taken along line F-F' of FIG. 14B.
FIG. 16A is a cross-sectional view taken along line E-E' of FIG. 16B.
FIG. 16B is a plan view obtained from FIG. 16A and FIG. 17.
FIG. 17 is a cross-sectional view taken along line F-F' of FIG. 16B.
FIG. 18 is a schematic cross-sectional view of a pixel device according to yet another exemplary embodiment.
FIG. 19 is a schematic plan view showing relative positions of some components shown in FIG. 18.
FIG. 20 is a schematic cross-sectional view of a pixel device according to yet another exemplary embodiment.
FIG. 21 is a schematic cross-sectional view of a pixel device according to yet another exemplary embodiment.

### [Best Mode]

Hereinafter, exemplary embodiments of the present disclosure will be described with reference to the accompanying drawings. It should be understood that the following embodiments are provided for complete disclosure and thorough understanding of the present disclosure by those skilled in the art. Therefore, the present disclosure is not limited to the following embodiments and may be embodied in different ways. In addition, the drawings may be exaggerated in width, length, and thickness of components for descriptive convenience and clarity only. When an element is referred to as being "on" or "under" another element, it may be directly on or under the other element or intervening elements or layers may be present. Like components will be denoted by like reference numerals throughout the specification.

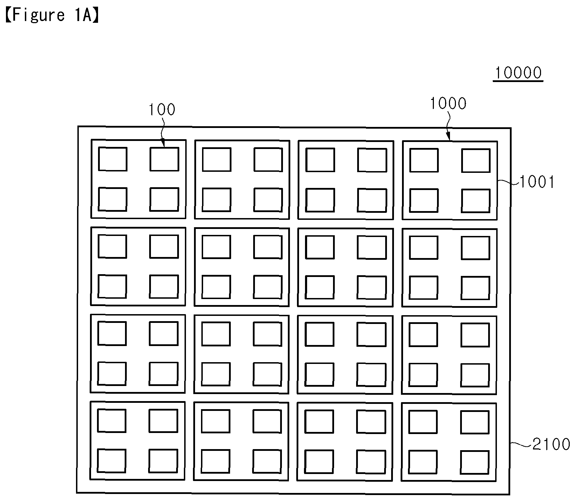

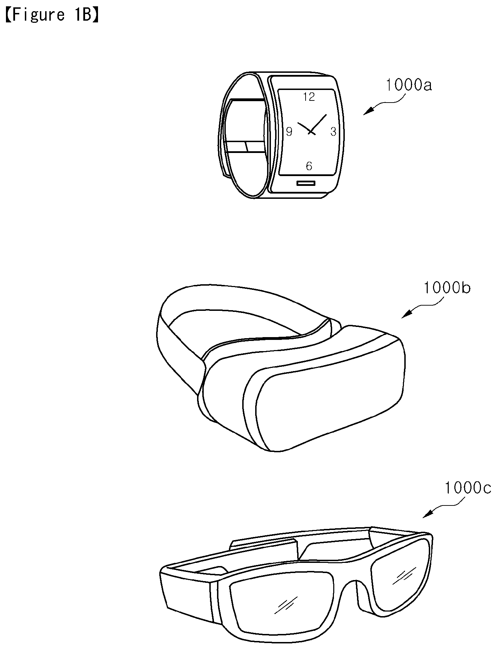

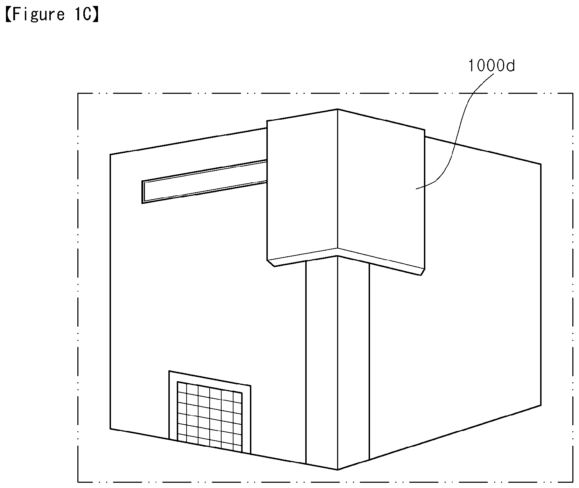

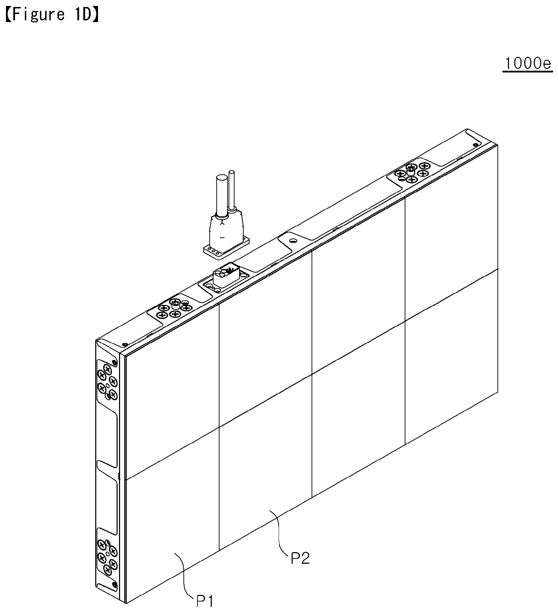

FIG. 1A is a schematic plan view of a display apparatus according to an exemplary embodiment, and FIG. 1B, FIG. 1C and FIG. 1D are schematic perspective views of various display apparatuses 1000a, 1000b, 1000c, 1000d, 1000e according to exemplary embodiments.

Referring to FIG. 1A, the display apparatus 10000 may include a panel substrate 2100 and multiple pixel modules 1000.

The display apparatus 10000 may include a smart watch 1000a, a wearable display apparatus 1000b, such as a VR headset or glasses, an AR display apparatus 1000c, such as augmented reality glasses, or indoor or outdoor display apparatuses 1000d, 1000e, such as micro-LED TVs and sign boards, without being limited thereto. The panel substrate 2100 and the multiple pixel modules 1000 may be disposed inside the display apparatus.

The panel substrate 2100 may be formed of various materials, such as polyimide (PI), FR4, glass, and the like, and may include circuits for passive matrix driving or active matrix driving. In one exemplary embodiment, the panel substrate 2100 may include interconnections and resistors therein. In another exemplary embodiment, the panel substrate 2100 may include interconnections, transistors, capacitors, and the like. The panel substrate 2100 may include pads for electrical connection to circuits on an upper surface thereof.

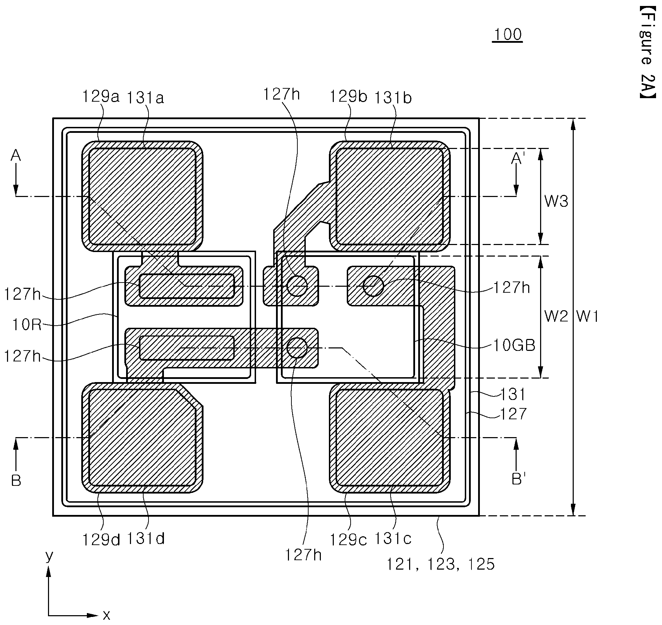

The multiple light emitting modules 1000 may be arranged on the panel substrate 2100. The light emitting modules 1000 may be arranged at certain intervals or may be arranged to contact each other. A distance between the light emitting modules 1000 may be set in consideration of a space between pixel devices 100 described below. For example, a distance between two adjacent pixel devices 100 disposed in adjacent light emitting modules 1000 may be substantially the same as the distance between the pixel devices 100 in one light emitting module 1000. However, it should be understood that other implementations are possible. Next, the pixel device 100 will be described in detail with reference to FIG. 2A to FIG. 2C.

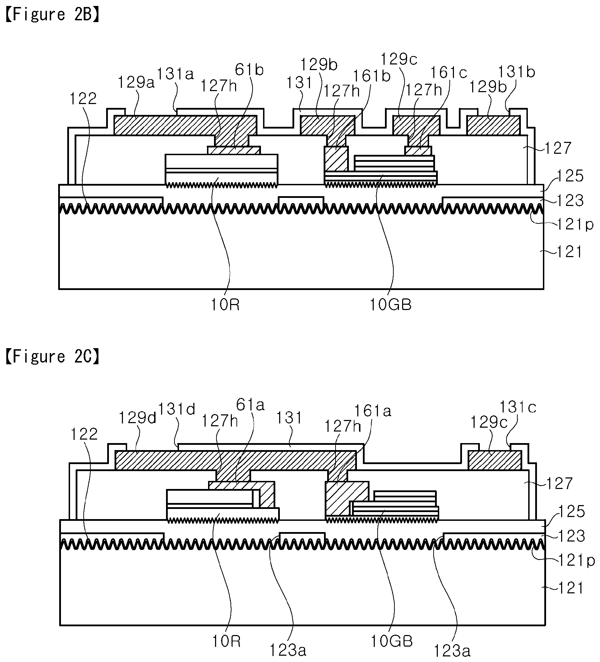

FIG. 2A is a schematic plan view of a pixel device according to an exemplary embodiment, FIG. 2B is a cross-sectional view taken along line A-A' of FIG. 2A, and FIG. 2C is a cross-sectional view taken along line B-B' of FIG. 2A.

Referring to FIG. 2A, FIG. 2B and FIG. 2C, the pixel device 100 may include a first light emitting device 10R, a second light emitting device 10GB, and connection layers 129a, 129b, 129c, 129d. In certain exemplary embodiments, the pixel device 100 may further include a transparent substrate 121, a surface layer 122, a light blocking layer 123, a bonding layer 125, a first cover layer 127, or a second cover layer 131.

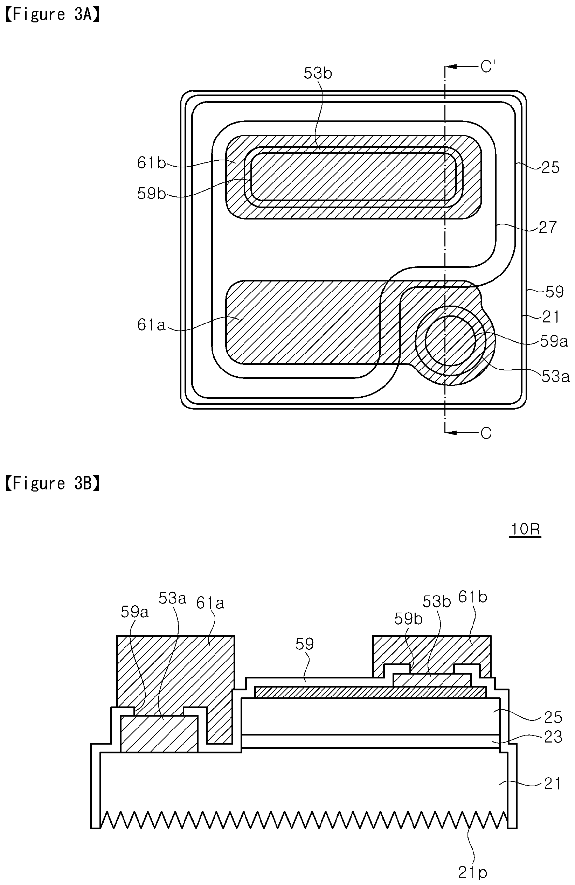

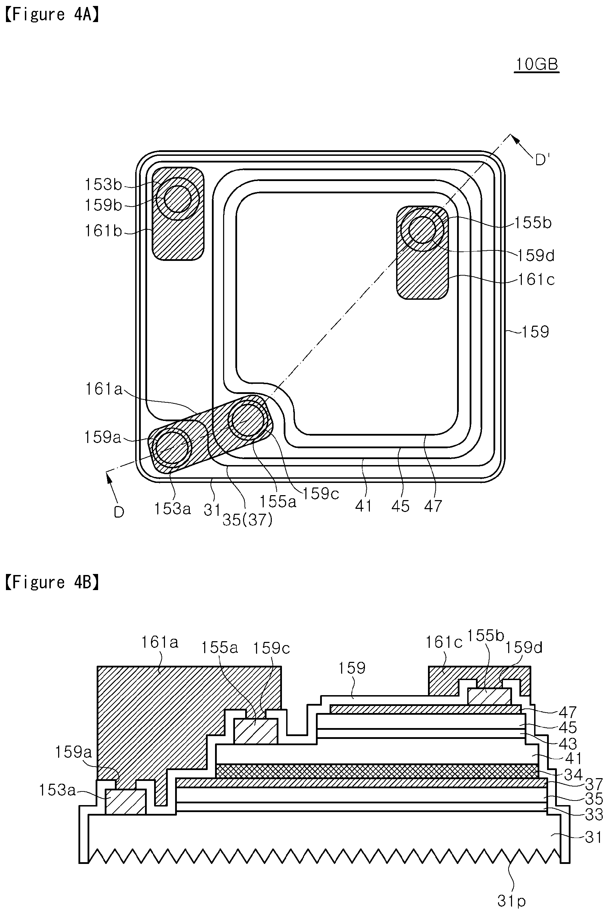

The pixel device 100 provides a single pixel including first and second light emitting devices 10R, 10GB to implement various colors. The first and second light emitting devices 10R, 10GB will be described below in detail with reference to FIG. 3A, FIG. 3B, FIG. 4A, and FIG. 4B.

The transparent substrate 121 is a light-transmissive substrate, such as PET, a glass substrate, quartz, a sapphire substrate, and the like. The transparent substrate 121 is disposed on a light emission surface of a light emitting module 1000 and light emitted from light emitting devices 10R, 10GB is discharged through the transparent substrate 121. The transparent substrate 121 may have an upper surface and a lower surface. The transparent substrate 121 may include a roughness pattern 121p formed on a surface thereof facing the light emitting devices 10R, 10GB, that is, on the upper surface thereof. The roughness pattern 121p increases the beam angle by scattering light emitted from the light emitting devices 10R, 10GB. In addition, the roughness pattern 121p may allow light emitted from the light emitting devices 10R, 10GB having different beam angles to be emitted at a uniform beam angle. As a result, the roughness patterns can prevent color differences from occurring depending on viewing angle.

The roughness pattern 121p may be regular or irregular. For example, the roughness pattern 121p may have a pitch of 3 *µ*m, a diameter of 2.8 *µ*m, and a height of 1.8 *µ*m. The roughness pattern 121p may be a typical pattern applied to a patterned sapphire substrate, without being limited thereto.

The transparent substrate 121 may further include an anti-reflective coating or an anti-glare layer, or may be subjected to anti-glare treatment. The transparent substrate 121 may have a thickness of, for example, 50 *µ*m to 300 *µ*m. The thickness of the transparent substrate 121 may be greater than a thickness of each of the light emitting devices 10R, 10GB.

Since the transparent substrate 121 is disposed on the light emission surface, the transparent substrate 121 does not include a circuit. However, it should be understood that other implementations are possible. Alternatively, the transparent substrate 121 may include a circuit. On the other hand, although a single pixel device 100 is formed on the transparent substrate 121, multiple pixel devices 100 may be formed on a single transparent substrate 121.

The surface layer 122 may cover the roughness pattern 121 on the transparent substrate 121. The surface layer 122 may be formed corresponding to the shape of the roughness pattern 121p. The surface layer 122 may enhance bonding strength of the light blocking layer 123 formed thereon. For example, the surface layer 122 may be formed of silicon oxide. The surface layer 122 may be omitted depending on the kind of transparent substrate 121.

The light blocking layer 123 is formed on the upper surface of the transparent substrate 121. The light blocking layer 123 may adjoin the surface layer 122. The light blocking layer 123 may include a light absorbing material, such as carbon black. The light absorbing material prevents light generated from the light emitting devices 10R, 10GB from leaking laterally from a region between the transparent substrate 121 and the light emitting devices 10R, 10GB and improves contrast of the display apparatus.

The light blocking layer 123 may have windows 123a, 123b, 123c for light traveling paths along which light generated by the light emitting devices 10R, 10GB enters the transparent substrate 121. To this end, the light blocking layer 123 may be patterned to expose the transparent substrate 121. The windows 123a, 123b, 123c may have a greater width than the light emitting device, without being limited thereto. Alternatively, the windows may have the same width as or a smaller width than the light emitting device.

The window 123a of the light blocking layer 123 may define alignment positions of the light emitting devices 10R, 10GB. Accordingly, it is possible to omit separate alignment markers for defining the alignment positions of the light emitting devices 10R, 10GB. However, it should be understood that other implementations are possible and the alignment markers for defining the alignment positions of the light emitting devices 10R, 10GB may be disposed on the transparent substrate 121, the light blocking layer 123 or the bonding layer 125. The light blocking layer 123 may be omitted.

The bonding layer 125 is attached to the upper surface of the transparent substrate 121. The bonding layer 125 is disposed between the upper surface of the transparent substrate 121 having the roughness pattern 121p and the light emitting devices 10R, 10GB. The bonding layer 125 may cover the light blocking layer 123. The bonding layer 125 may be attached to an overall surface of the transparent substrate 121, without being limited thereto. Alternatively, the bonding layer 125 may be attached to some region of the transparent substrate 121 so as to expose a region near a periphery of the transparent substrate 121. The bonding layer 125 serves to attach the light emitting devices 10R, 10GB to the transparent substrate 121. The window 123a of the light blocking layer 123 may be filled with the bonding layer 125.

The bonding layer 125 may be formed of a light transmitting material and transmits light emitted from the light emitting devices 10R, 10GB. The bonding layer 125 may be formed of an organic bonding agent. For example, the bonding layer 125 may be formed of a transparent epoxy. In addition, the bonding layer 125 may contain a light diffusive material, such as SiO₂, TiO₂, ZnO, and the like, in order to spread light. The light diffusive material prevents the light emitting devices 10R, 10GB from being observed on the light emission surface.

As shown in FIG. 2B and FIG. 2C, the bonding layer 125 may partially cover side surfaces of the light emitting devices 10R, 10GB. That is, some region of the light emitting devices 10R, 10GB may be buried in the bonding layer 125, thereby preventing separation of the light emitting devices 10R, 10GB from the pixel device while preventing moisture from entering a space at an interface between the bonding layer 125 and the light emitting devices 10R, 10GB. On the other hand, the bonding layer 125 may cover the roughness pattern 121p and thus may include regions having different thicknesses. A region of the bonding layer 125 having a greater thickness than other regions thereof enhances bonding strength of the bonding layer 125. The light emitting devices 10R, 10GB can be detached from the pixel device due to heat generated from the light emitting devices 10R, 10GB upon operation of the light emitting devices. As the bonding layer 125 has both a thick region and a thin region, the bonding layer 125 can absorb shrinkage and expansion due to heat from the light emitting devices 10R, 10GB, thereby preventing separation of the light emitting devices from the pixel device.

The first and second light emitting devices 10R, 10GB are disposed on the transparent substrate 121. The first and second light emitting devices 10R, 10GB may be attached to the transparent substrate 121 by the bonding layer 125. The first and second light emitting devices 10R, 10GB may be disposed corresponding to the windows 123a of the light blocking layer 123. When the light blocking layer 123 is omitted, alignment markers may be added to provide the alignment positions of the light emitting devices 10R, 10GB. The first and second light emitting devices 10R, 10GB may share a single transparent substrate 121. The first and second light emitting devices 10R, 10GB may be disposed adjacent to each other. The first light emitting device 10R may be disposed in a first region of the pixel device 100 and the second light emitting device 10GB may be disposed in a second region of the pixel device 100. The first light emitting device 10R may include a first light emitting structure emitting light having the longest peak wavelength in the pixel device 100 and the second light emitting device 10GB include second and third light emitting structures emitting light having shorter peak wavelengths than the first light emitting device 10R. The second and third light emitting structures may emit light having different peak wavelengths.

The first and second light emitting devices 10R, 10GB may be arranged side by side, as shown in FIG. 2A. The first light emitting structure may have a greater thickness than each of the second and third light emitting structures. In addition, a first plane of the first light emitting structure disposed in the first region may face first planes of the second and third light emitting structures disposed in the second region. A vertical height of the first plane of the first light emitting structure may be smaller than the total vertical height of the first planes of the second and third light emitting structures. Further, light emitted from the first region may have a different peak wavelength than light emitted from the second region. Further, the light emitted from the first region may have different color coordinates than the light emitted from the second region, and white light may be generated by simultaneously applying electric current to the first and second regions. The second light emitting structure may include an upper surface facing the light transmitting substrate and a lower surface opposite the upper surface thereof. The third light emitting structure is formed on the lower surface of the second light emitting structure. The second light emitting structure and the third light emitting structure may at least partially overlap each other, thereby enabling minimization of the pixel device.

For example, the first light emitting structure of the first light emitting device 10R may have the narrowest energy band-gap and may emit red light. The second light emitting structure of the second light emitting device 10GB may have a wider energy band-gap than the first light emitting structure and may emit green light. The third light emitting structure of the second light emitting device 10GB may have a wider energy band-gap than the second light emitting structure and may emit blue light. Since the first light emitting device 10R emitting red light does not overlap the light emitting structures emitting light having different peak wavelengths, red light can be discharged without any light loss that can occur while passing through the other light emitting structures, thereby improving emission efficiency of red light.

The first light emitting device 10R will be described in detail with reference to FIG. 3A and FIG. 3B and the second light emitting device 10GB will be described in detail with reference to FIG. 4A and FIG. 4B.

The first cover layer 127 covers the first and second light emitting devices 10R, 10GB. The first cover layer 127 has openings 127h that expose electrode pads of the light emitting devices 10R, 10GB. The first cover layer 127 assists in stable formation of the connection layers 129a, 129b, 129c, 129d through adjustment in height of a plane on which the connection layers 129a, 129b, 129c, 129d are formed. The first cover layer 127 may be formed of a material, for example, polyimide, epoxy molding compounds, silicone, and the like. The first cover layer 127 may include a light reflective material or a light absorbing material. The first cover layer 127 covering the first and second light emitting devices 10R, 10GB may have a lower surface contacting the bonding layer 125, whereby the light emitting devices 10R, 10GB are buried in the bonding layer 125 and the first cover layer 127, thereby preventing deformation, such as bending and the like, of the light emitting devices 10R, 10GB and damage thereto in the course of moving and mounting the pixel device 100.

The first cover layer 127 may be disposed in a region surrounded by the periphery of the bonding layer 125, without being limited thereto. For example, the first cover layer 127 may be formed to expose a portion of the periphery of the bonding layer 125.

The first to fourth connection layers 129a, 129b, 129c, 129d are formed on the first cover layer 127. The first to fourth connection layers 129a, 129b, 129c, 129d may contact the electrode pads 61a, 61b, 161a, 161b, 161c of the first and second light emitting devices 10R, 10GB through the openings 127h of the first cover layer 127. The first to fourth connection layers 129a, 129b, 129c, 129d are electrically connected to the first and second light emitting devices 10R, 10GB and extend to the outside of the first and second regions in which the first and second light emitting devices 10R, 10GB are disposed.

In one exemplary embodiment, as shown in FIG. 2A and FIG. 2B, the first connection layer 129a may be electrically connected to a second conductivity type semiconductor layer of the first light emitting structure of the first light emitting device 10R; the second connection layer 129b may be electrically connected to the second conductivity type semiconductor layer of the second light emitting structure of the second light emitting device 10GB; the third connection layer 129c may be electrically connected to the second conductivity type semiconductor layer of the third light emitting structure of the second light emitting device 10GB; and the fourth connection layer 129d may be commonly electrically connected to a first conductivity type semiconductor layers of the first and second light emitting devices 10R, 10GB. In another exemplary embodiment; the first connection layer 129a may be electrically connected to the first conductivity type semiconductor layer of the first light emitting structure of the first light emitting device 10R; the second connection layer 129b may be electrically connected to the first conductivity type semiconductor layer of the second light emitting structure of the second light emitting device 10GB; the third connection layer 129c may be electrically connected to the first conductivity type semiconductor layer of the third light emitting structure of the second light emitting device 10GB; and the fourth connection layer 129d may be commonly electrically connected to the second conductivity type semiconductor layers of the first and second light emitting devices 10R, 10GB. The first to fourth connection layers 129a, 129b, 129c, 129d may be formed on the first cover layer 127 and may include, for example, Au.

The second cover layer 131 may have a thinner thickness than the first cover layer 127. The sum of the thicknesses of the second cover layer 131 and the first cover layer 127 may range from 1 *µ*m to 50 *µ*m, without being limited thereto.

The second cover layer 131 may cover a side surface of the first cover layer 127 and the connection layers 129a, 129b, 129c, 129d. In addition, the second cover layer 131 may cover a portion of the bonding layer 125. The second cover layer 131 may include openings 131a, 131b, 131c, 131d that expose the connection layers 129a, 129b, 129c, 129d, whereby pad regions of the pixel device 100 can be defined. The pad regions may be placed near corners of the pixel device 100, respectively, and may be symmetrical with respect to a central line of the pixel device 100. The pad regions may be formed outside upper regions of the first and second light emitting devices 10R, 10GB so as not to overlap the first and second light emitting devices 10R, 10GB in the vertical direction. However, it should be understood that other implementations are possible.

A length of an edge of at least one of the pad regions may be 25% or less of a length of at least one edge of the pixel device 100. The edges of the connection layers 129a, 129b, 129c, 129d may be covered by the second cover layer 131 and the pad regions may be covered by pads or a bonding material on the circuit substrate.

In one exemplary embodiment, the second cover layer 131 may be formed of a translucent organic or inorganic material. The second cover layer 131 may be formed of the same material as the first cover layer 127. This structure can minimize formation of an interface inside the pixel device 100 to prevent generation of air gaps due to heat generated upon operation of the pixel device. For example, both the first cover layer 127 and the second cover layer 131 may be formed of polyimide. In this case, lower, side and upper surfaces of the connection layers 129a, 129b, 129c, 129d excluding the pad regions may be surrounded by polyimide.

The pixel device 100 may be mounted on the circuit substrate by a bonding material, such as solders and the like. The bonding material bonds the connection layers 129a, 129b, 129c, 129d, which are exposed through the openings 131a, 131b, 131c, 131d of the second cover layer 131, to the pads on the circuit substrate.

According to this embodiment, the pixel device 100 does not include separate bumps and uses the connection layers 129a, 129b, 129c, 129d as bonding pads, without being limited thereto. Alternatively, the pixel device 100 may further include bonding pads that cover the openings 131a, 131b, 131c, 131d of the second cover layer 131. In one exemplary embodiment, the bonding pads may be formed to partially cover the light emitting devices 10R, 10GB outside upper regions of the first to fourth connection layers 129a, 129b, 129c, 129d.

Referring again to FIG. 2A, one side surface of the pixel device 100 may have a length W1 of 300 *µ*m or less and the pixel device 100 may have an area of 300 *µ*m×300 *µ*m or less. One side surface of each of the first light emitting device 10R and the second light emitting device 10GB may have a length W2 of 100 *µ*m or less and each of the first and second light emitting devices 10R, 10GB may have an area of 100 *µ*m×100 *µ*m or less, 50 *µ*m×50 *µ*m or less, or 10 *µ*m×10 *µ*m or less. On the other hand, one side surface of the openings of the second cover layer 131 may have a length of W3 or 70 *µ*m or less. In one exemplary embodiment, W1, W2 and W3 may be set to satisfy a relation: W1>W2>W3. When W3 is set to the smallest value, the length W1 of the pixel device 100 can be minimized. In addition, when W2 is less than W3, with pixel devices 100 disposed adjacent each other, a distance between the first region of one pixel device and the second region of another pixel device adjacent to the one pixel device increases, thereby making it difficult to increase pixel density. When W2 is greater than W3, the distance between adjacent pixel devices 100 can be reduced.

Although the light emitting devices 10R, 10GB are illustrated as being attached to the transparent substrate 121 by the bonding layer 125 in this embodiment, the light emitting devices 10R, 10GB may be coupled to the transparent substrate 121 by other couplers instead of the bonding layer 125. For example, the light emitting devices 10R, 10GB may be coupled to the transparent substrate 121 by spacers, whereby regions between the light emitting devices 10R, 10GB and the transparent substrate 121 may be filled with a gas or liquid. By the gas or the liquid, an optical layer allowing transmission of light emitted from the light emitting devices 10R, 10GB may be formed. The bonding layer 125 described above is one example of the optical layer. Here, the optical layer is formed of a different material, for example, a gas, a liquid, or a solid, from the material of the light emitting devices 10R, 10GB. Accordingly, the material of the optical layer is distinguished from the materials of the semiconductor layers in the light emitting devices 10R, 10GB.

In this embodiment, the first region and the second region may have a square shape. However, it should be understood that other implementations are possible. Alternatively, the first region and the second region may have a rectangular shape. In this embodiment, the long sides of the first and second regions may be placed side by side so as to face each other. When multiple light emitting structures are stacked in the first region or in the second region, the multiple light emitting structures may have different sizes. Preferably, a light emitting structure disposed near the transparent substrate 121 has a greater size than other light emitting structures.

According to this embodiment, the pixel device 100 includes the light emitting devices 10R, 10GB arranged on the same plane. The pixel device 100 may realize various colors of light using the light emitting devices 10R, 10GB. Hereinafter, the light emitting devices 10R, 10GB according to one exemplary embodiment will be described in detail.

FIG. 3A is a schematic plan view of the light emitting device 10R according to an exemplary embodiment and FIG. 3B is a cross-sectional view taken along line C-C' of FIG. 3A.

Referring to FIG. 3A and FIG. 3B, the light emitting device 10R may include a first light emitting structure, which includes a first conductivity type semiconductor layer 21, an active layer 23 and a second conductivity type semiconductor layer 25, an ohmic contact layer 27, a first contact pad 53a, a second contact pad 53b, an insulating layer 59, a first electrode pad 61a, and a second electrode pad 61b.

The first light emitting structure, that is, the first conductivity type semiconductor layer 21, the active layer 23 and the second conductivity type semiconductor layer 25, may be grown on the substrate. The substrate may be selected from various substrates, such as a gallium nitride substrate, a GaAs substrate, a Si substrate, a sapphire substrate, and the like, particularly, a patterned sapphire substrate, which can be used for growth of semiconductor layers. The growth substrate may be separated from the semiconductor layers using techniques such as mechanical polishing, laser lift-off, chemical lift-off, and the like. The substrate may be, for example, a GaAs substrate, and may be removed from the first conductivity type semiconductor layer 21 by chemical etching technology.

In one exemplary embodiment, the first light emitting structure may include aluminum gallium arsenide (AlGaAs), gallium arsenide phosphide (GaAsP), aluminum gallium indium phosphide (AlGaInP), or gallium phosphide (GaP), and may emit red light.

The first conductivity type and the second conductivity type are opposite polarities. When the first conductivity type is n-type, the second conductivity type is p-type, and when the second conductivity type is p-type, the first conductivity type is n-type.

The first conductivity type semiconductor layer 21, the active layer 23 and the second conductivity type semiconductor layer 25 may be grown on the substrate in a chamber by a method known in the art, such as metal organic chemical vapor deposition (MOCVD). In addition, the first conductivity type semiconductor layer 21 includes n-type dopants (for example, Si, Ge, and Sn) and the second conductivity type semiconductor layer 25 includes p-type dopants (for example, Mg, Sr, and Ba).

Although each of the first conductivity type semiconductor layer 21 and the second conductivity type semiconductor layer 25 is shown as a single layer, these layers may be composed of multiple layers and may include super-lattice layers. The active layer 23 may include a single quantum well structure or a multi-quantum well structure and may have a semiconductor composition to emit light in a target wavelength. For example, the active layer 23 may emit red light.

The second conductivity type semiconductor layer 25 and the active layer 23 may have a mesa structure and may be disposed on the first conductivity type semiconductor layer 21. The mesa may include the second conductivity type semiconductor layer 25 and the active layer 23, and may include a portion of the first conductivity type semiconductor layer 21, as shown in FIG. 3B. The mesa may be placed in some region on the first conductivity type semiconductor layer 21 and an upper surface of the first conductivity type semiconductor layer 21 may be exposed around the mesa.

In this embodiment, the mesa may be formed to expose the first conductivity type semiconductor layer 21 therearound. In another exemplary embodiment, a through-hole may be form in the mesa to expose the first conductivity type semiconductor layer 21.

On the other hand, the first conductivity type semiconductor layer 21 may have a roughness pattern 21p formed through surface texturing. The roughness pattern 21p may be formed on a light emission surface of the first conductivity type semiconductor layer 21. Surface texturing may be performed by patterning using, for example, dry etching or wet etching.

In one exemplary embodiment, cone-shaped protrusions may be formed at an interval of 1.5 *µ*m to 2 *µ*m thereon and may have a height of 2 *µ*m to 3 *µ*m and a bottom diameter of about 3 *µ*m to about 5 *µ*m. The cones may have a frustoconical shape, which may have a diameter of about 2 *µ*m to 3 *µ*m on an upper surface thereof.

In another exemplary embodiment, the roughness pattern 21p may include a first roughness pattern and a second roughness pattern formed on the first roughness pattern. The second roughness pattern may have a finer size than the first roughness pattern. With the structure that the roughness pattern 21p is formed on the surface of the first conductivity type semiconductor layer 21, the light emitting device can improve light extraction efficiency through reduction in internal total reflection.

The ohmic contact layer 27 is disposed on the second conductivity type semiconductor layer 25 to form ohmic contact with the second conductivity type semiconductor layer 25. The ohmic contact layer 27 may be composed of a single layer or multiple layers and may be a transparent conductive layer or a metal layer. The transparent conductive layer may be formed of, for example, ITO, ZnO, or the like, and the metal layer may be formed of, for example, a metal, such as Al, Ti, Cr, Ni, Au, and the like, and alloys thereof.

The first contact pad 53a is disposed in an exposed region on the first conductivity type semiconductor layer 21. The first contact pad 53a may form ohmic contact with the first conductivity type semiconductor layer 21. For example, the first contact pad 53a may be an ohmic metal layer forming ohmic contact with the first conductivity type semiconductor layer 21. The ohmic contact layer of the first contact pad 53a may be suitably selected depending on the semiconductor material of the first conductivity type semiconductor layer 21. The first contact pad 53a may be omitted.

The second contact pad 53b may be disposed on the ohmic contact layer 27. The second contact pad 53b may be electrically connected to the ohmic contact layer 27. The second contact pad 53b may be omitted.

The insulating layer 59 may cover the mesa, the ohmic contact layer 27, the first contact pad 53a, and the second contact pad 53b. The insulating layer 59 has openings 59a, 59b that expose the first contact pad 53a and the second contact pad 53b. The insulating layer 59 may be composed of a single layer or multiple layers. Furthermore, the insulating layer 59 may include a distributed Bragg reflector in which insulating layers having different indexes of refraction are stacked one above another. For example, the distributed Bragg reflector may include at least two types of insulating layers selected from among SiO₂, Si₃N₄, SiON, TiO₂, Ta₂O₅, and Nb₂O₅.

The distributed Bragg reflector reflects light emitted from the active layer 23. The distributed Bragg reflector may exhibit high reflectance over a relatively wide wavelength range including the peak wavelength of light emitted from the active layer 23 and may be designed in consideration of incidence angle of light. In one exemplary embodiment, the distributed Bragg reflector may exhibit higher reflectance with respect to light incident thereon at an incidence angle of 0 degrees than light incident at other incidence angles. In another exemplary embodiment, the distributed Bragg reflector may exhibit higher reflectance with respect to light incident at other incidence angles than light incident thereon at an incidence angle of 0 degrees. For example, the distributed Bragg reflector may exhibit higher reflectance with respect to light incident at an incidence angle of 10 degrees than light incident thereon at an incidence angle of 0 degrees.

The first electrode pad 61a and the second electrode pad 61b are disposed on the insulating layer 59. The first electrode pad 61a may extend from the top of the first contact pad 53a to the top of the mesa and the second electrode pad 61b may be disposed in an upper region of the mesa. The first electrode pad 61a may be electrically connected to the first contact pad 53a through the opening 59a and the second electrode pad 61b may be electrically connected to the second contact pad 53b. The first electrode pad 61a may form direct ohmic contact with the first conductivity type semiconductor layer 21. In this case, the first contact pad 53a may be omitted. When the second contact pad 53b is omitted, the second electrode pad 61b may be directly connected to the ohmic contact layer 27.

The first and/or second electrode pads 61a, 61b may be composed of a single metal layer or multiple metal layers. The first and/or second electrode pads 61a, 61b may be formed of a metal, such as Al, Ti, Cr, Ni, Au, and the like, and alloys thereof.

Although the light emitting device 10R according to the exemplary embodiment is briefly described above with reference to the drawings, the light emitting device 10R may further include other functional layers. For example, the light emitting device may further include a reflective layer, an additional insulating layer for insulation of a particular component, an anti-solder layer for preventing diffusion of solders, and the like.

Further, in formation of a flip-chip type light emitting device, the mesa may be formed in various shapes and the positions or shapes of the first and second electrode pads 61a, 61b may be changed in various ways. Further, the ohmic contact layer 27 may be omitted and the second contact pad 53b or the second electrode pad 61b may directly contact the second conductivity type semiconductor layer 25.

Although the first light emitting device 10R is illustrated by way of example as having the flip-chip structure in this embodiment, it should be understood that other implementations are possible. Alternatively, the first light emitting device 10R may be a horizontal type light emitting device.

FIG. 4A is a schematic plan view of a second light emitting device 10GB according to an exemplary embodiment and FIG. 3B is a cross-sectional view taken along line D-D' of FIG. 4A.

Referring to FIG. 4A and FIG. 4B, the second light emitting device 10GB includes a second light emitting structure including a first conductivity type semiconductor layer 31, an active layer 33 and a second conductivity type semiconductor layer 35, and a third light emitting structure including a first conductivity type semiconductor layer 41, an active layer 43 and a second conductivity type semiconductor layer 45. The second light emitting device 10GB may include ohmic contact layers 37, 47, first contact pads 153a, 155a, second contact pads 153b, 155b, electrode pads 161a, 161b, 161c, a bonding layer 34, and an insulating layer 159.

Light generated from the active layer 33 of the second light emitting structure and the active layer 43 of the third light emitting structure is discharged through the first conductivity type semiconductor layer 31 of the second light emitting structure. In general, the active layer 43 of the third light emitting structure may emit light having a longer peak wavelength than the active layer 33 of the second light emitting structure. For example, the third light emitting structure may emit green light and the second light emitting structure may blue light. In some embodiments, in order to adjust relative intensity of light emitted from the second light emitting structure and the third light emitting structure, the second light emitting structure may emit light having a longer wavelength than the third light emitting structure. For example, the second light emitting structure may emit green light and the third light emitting structure may emit blue light. With this structure, the second light emitting device can reduce the intensity of light emitted from the third light emitting structure while increasing the intensity of light emitted from the second light emitting structure.

Semiconductor layers in the second and third light emitting structures may be selected to emit light having target peak wavelengths. The first conductivity type semiconductor layers 31, 41 and the second conductivity type semiconductor layers 33, 43 may be composed of a single layer or multiple layers, and the active layers 33, 43 may have a single quantum well structure or a multi-quantum well structure. For a light emitting structure emitting green light, the semiconductor layers may include indium gallium nitride (InGaN), gallium nitride (GaN), gallium phosphide (GaP), aluminum gallium indium phosphide (AlGaInP), or aluminum gallium phosphide (AlGaP), and for a light-emitting structure emitting blue light, the semiconductor layers may include gallium nitride (GaN), indium gallium nitride (InGaN), or zinc selenide (ZnSe).

The ohmic contact layer 37 is disposed on the second conductivity type semiconductor layer 35 to form ohmic contact with the second conductivity type semiconductor layer 35. The ohmic contact layer 37 may be composed of a single layer or multiple layers and may be a transparent conductive layer or a metal layer. The transparent conductive layer may be formed of, for example, ITO, ZnO, or the like, and the metal layer may be formed of, for example, a metal, such as Al, Ti, Cr, Ni, Au, and the like, and alloys thereof. The ohmic contact layer 37 may be formed of a light transmitting material that transmits light generated from the third light emitting structure.

The ohmic contact layer 47 is disposed on the second conductivity type semiconductor layer 45 to form ohmic contact with the second conductivity type semiconductor layer 45. The ohmic contact layer 47 may be composed of a single layer or multiple layers and may be a transparent conductive layer or a metal layer. The transparent conductive layer may be formed of, for example, ITO, ZnO, or the like, and the metal layer may be formed of, for example, a metal, such as Al, Ti, Cr, Ni, Au, and the like, and alloys thereof.

The bonding layer 34 may bond the second light emitting structure to the third light emitting structure. The bonding layer 34 may include an optically clear adhesive (OCA), for example, epoxy, polyimide, SU8, spin-on-glass (SOG), and benzocyclobutene (BCB), without being limited thereto.

The first contact pads 153a, 155a may be disposed on the first conductivity type semiconductor layers 31, 41 to form ohmic contact therewith, respectively. The first conductivity type semiconductor layer 31 may be partially exposed and the first contact pad 153a may be formed in an exposed region on the first conductivity type semiconductor layer 31. In addition, the first conductivity type semiconductor layer 41 may be partially exposed and the first contact pad 155a may be formed in an exposed region on the first conductivity type semiconductor layer 41.

The second contact pads 153b, 155b are electrically connected to the second conductivity type semiconductor layers 33, 43, respectively. The second contact pads 153b, 155b may be formed on the ohmic contact layers 37, 47, respectively.

The insulating layer 159 may cover the second light emitting structure and the third light emitting structure, and may also cover the ohmic contact layers 37, 47, the first contact pads 153a, 155a and the second contact pads 153b, 155b. The insulating layer 159 may cover a side surface of the first conductivity type semiconductor layer 31. The insulating layer 159 may have openings 159a, 159b, 159c, 159d that expose the first contact pads 153a, 155a and the second contact pads 153b, 155b to allow electrical connection thereto.

The electrode pads 161a, 161b, 161c are formed on the insulating layer 159 and may be electrically connected to the first contact pads 153a, 155a and the second contact pads 153b, 155b. The electrode pad 161a may electrically connect the first contact pad 153a to the first contact pad 155a. Accordingly, the first conductivity type semiconductor layer 31 may be electrically connected to the first conductivity type semiconductor layer 41. The electrode pad 161b may be electrically connected to the second contact pad 153b and the electrode pad 161c may be electrically connected to the second contact pad 155b. The electrode pads 161a, 161b, 161c are electrically insulated from one another. On the other hand, as shown in FIG. 2A, the fourth connection layer 129d may be connected to the electrode pad 161a to be commonly electrically connected to the first conductivity type semiconductor layers 31, 41 of the second light emitting device 10GB.

In this embodiment, the third light emitting structure may have a smaller area than the second light emitting structure. However, it should be understood that other implementations are possible. For example, electrical connection may be achieved through contact holes that expose the first conductivity type semiconductor layer 31, the ohmic contact layer 37, and the first conductivity type semiconductor layer 41. In this example, the second light emitting structure may have the same external area as the third light emitting structure.

The second light emitting device 10GB may be formed at the wafer level using wafer bonding technology. After separation of the first conductivity type semiconductor layer 31 from the growth substrate, a roughness 31p may be formed on an exposed surface of the first conductivity type semiconductor layer 31, and the beam angle of light emitted from the second light emitting structure and the third light emitting structure may be adjusted using the roughness 31p. Furthermore, light extraction efficiency can be improved using light scattering by the roughness 31p.

According to this embodiment, the first light emitting device 10R emitting red light may be disposed independently of the second light emitting device 10GB emitting green light and blue light, thereby improving the intensity of red light. Furthermore, with the second light emitting device 10GB having the stack structure of the second light emitting structure and the third light emitting structure, the pixel device 100 can be minimized while enabling further simplification of a process of mounting the light emitting devices.

As shown in FIG. 1, the pixel device 100 is disposed on a circuit substrate 1001 to be mounted on the panel substrate 2100. Multiple pixel devices 100 are disposed on the circuit substrate 1001 to form light emitting modules 1000. Since pixels are disposed on the panel substrate 2100 by forming the light emitting modules 1000, a defective light emitting module 1000 can be repaired or replaced after identifying poor pixels within each of the light emitting modules 1000. Since only the defective light emitting module can be repaired or replaced, the display apparatus does not need to be entirely repaired or discarded, thereby reducing costs associated with defects.

Although the light emitting modules 1000 are illustrated as being mounted on the panel substrate 2100 in this embodiment, the light emitting modules 1000 may be mounted on a cabinet and multiple cabinets each having the light emitting modules 1000 mounted thereon may be mounted on the panel substrate 2100.

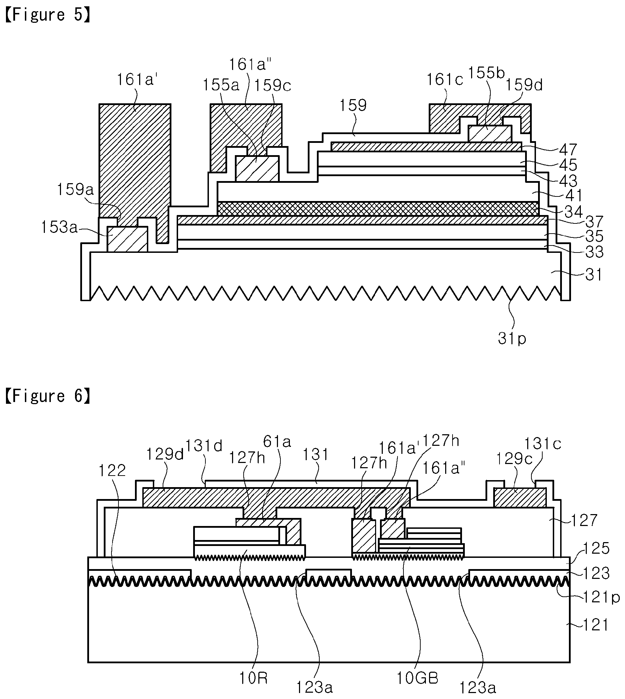

FIG. 5 is a schematic cross-sectional view of a second light emitting device according to another exemplary embodiment and FIG. 6 is a schematic cross-sectional view of a pixel device according to another exemplary embodiment.

Referring to FIG. 5, the second light emitting device according to this embodiment is generally similar to the second light emitting device 10GB described with reference to FIG. 4A and FIG. 4B and is distinguished therefrom in that electrode pads 161a', 161a" are disposed on the first contact pads 153a, 155a, respectively. Since the electrode pads 161a', 161a" are disposed on the first contact pads 153a, 155a, the first contact pads 153a, 155a are not required to be disposed adjacent each other, thereby increasing process tolerance.

Referring to FIG. 6, the connection layer 129d may be electrically connected to all of the electrode pads 161a', 161a" through the openings 127h of the first cover layer 127. As a result, the electrode pads 161a', 161a" may be electrically connected to each other. Thus, the first conductivity type semiconductor layers 31, 41 are electrically connected to each other.

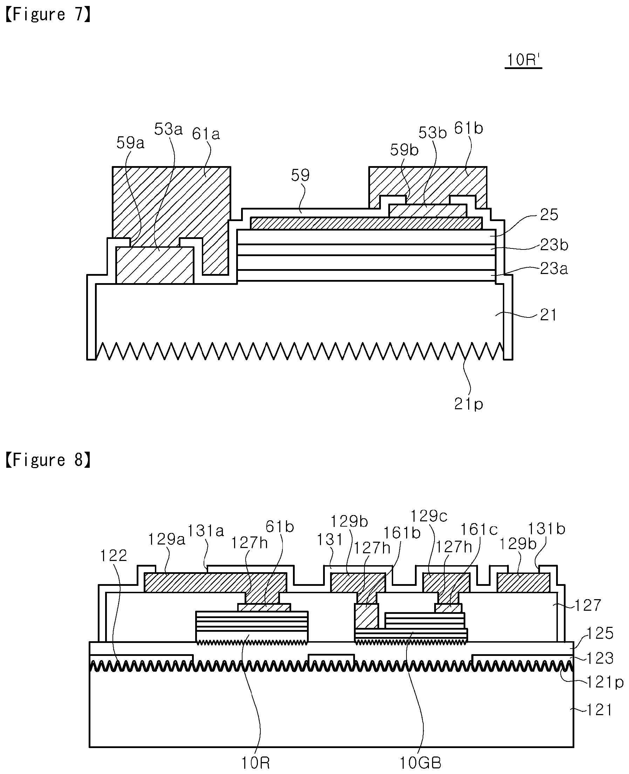

FIG. 7 is a schematic cross-sectional view of a first light emitting device 10R' according to another exemplary embodiment and FIG. 8 is a schematic cross-sectional view of a pixel device according to another exemplary embodiment.

Referring to FIG. 7, the first light emitting device 10R' according to this embodiment is generally similar to the first light emitting device 10R described with reference to FIG. 3A and FIG. 3B and is distinguished therefrom in that the first light emitting device 10R' includes multiple active layers 23a, 23b. That is, the first light emitting device 10R' may include a first light emitting structure including an active layer 23a and a sub-light emitting structure including an active layer 23b. The active layer 23b of the sub-light emitting structure may emit light having a longer wavelength than the second light emitting structure and the third light emitting structure. The active layers 23a, 23b may be formed of the semiconductor materials described with reference to FIG. 3A and FIG. 3B. The first light emitting structure and the sub-light emitting structure may be coupled to each other through a tunnel layer and may operate together. Accordingly, for example, when the active layers 23a, 23b emit light having the same or similar peak wavelengths, the intensity of light emitted from the first light emitting device 10R' can be increased. As shown in FIG. 8, the first light emitting device 10R' may be mounted on the pixel device instead of the first light emitting device 10R. The connection layer 129a may be electrically connected to the second conductivity type semiconductor layer 25 of the sub-light emitting structure and the first conductivity type semiconductor layer 21 may be electrically connected to the connection layer 129d, as shown in FIG. 2C.

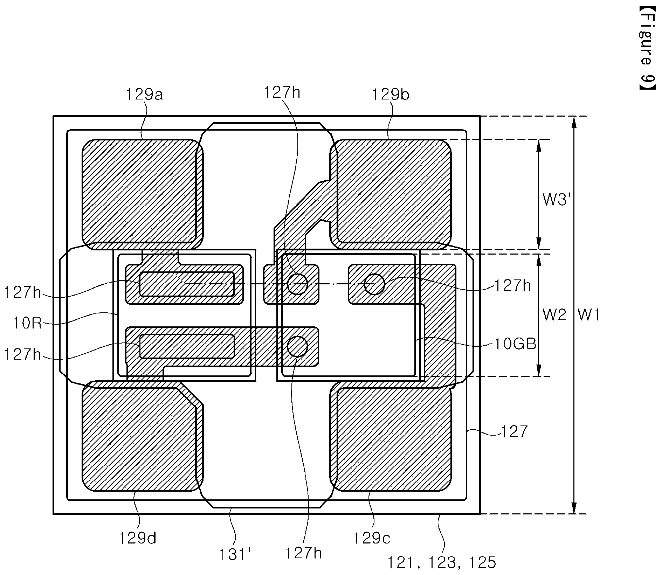

FIG. 9 is a schematic plan view of a pixel device according to a further exemplary embodiment.

Referring to FIG. 9, the pixel device according to this embodiment is generally similar to the pixel device 100 described with reference to FIG. 2A, FIG. 2B, and FIG. 2 and is distinguished therefrom in that a second cover layer 131' covers the first cover layer 127 and the connection layers 129a, 129b, 129c, 129d. As shown in FIG. 9, the second cover layer 131' exposes a central region of the pixel device while exposing corner regions thereof in the longitudinal direction and the transverse direction. In particular, the second cover layer 131' does not cover regions of the connection layer near the peripheries of the pixel device. Accordingly, the area of the exposed regions of the upper surfaces of the connection layers, that is, the area of pad regions, can be increased. That is, a length W3' of the pad regions may be greater than the length W3 of the pad region of the pixel device shown in FIG. 2A. Accordingly, it is possible to secure sufficient pad regions while achieving minimization of the pixel device.

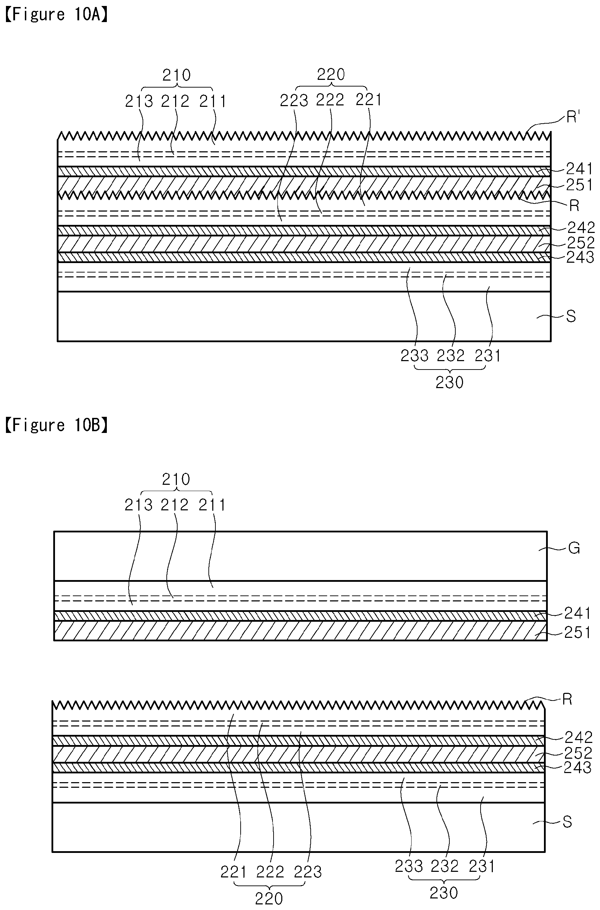

FIG. 10A shows a light emitting device according to an exemplary embodiment, which is disposed on a first substrate S. Referring to FIG. 10A, the light emitting device according to the exemplary embodiment includes a first light emitting stack 210, a second light emitting stack 220 disposed under the first light emitting stack 210, and a third light emitting stack 230 disposed under the second light emitting stack 220. The first light emitting stack 210 includes a first conductivity type semiconductor layer 211, an active layer 212, and a second conductivity type semiconductor layer 213. The second light emitting stack 220 includes a first conductivity type semiconductor layer 221, an active layer 222, and a second conductivity type semiconductor layer 223. The third light emitting stack 230 includes a first conductivity type semiconductor layer 231, an active layer 232, and a second conductivity type semiconductor layer 233. In addition, the active layers 212, 222, 232 of the light emitting stacks 210, 220, 230 may emit light having different peak wavelengths. For example, a process of bonding the light emitting stacks formed on a wafer to each other in a stack structure and dicing the light emitting stacks into individual chips may be performed at the same time, thereby enabling reduction in process time through elimination of a process of individually dicing the light emitting stacks.

The first light emitting stack 210 may emit light having the highest peak wavelength. Preferably, the first light emitting stack 210 emits red light. The first light emitting stack 210 may include at least one selected from among InGaN, InAlGaN, GaN, AlGaN, AlGaAs, GaAsP, AlGaInP, and GaP, without being limited thereto. However, it should be understood that any material capable of emitting red light may be used.

The second light emitting stack 220 may emit light having a shorter peak wavelength than the first light emitting stack 210. Preferably, the second light emitting stack 220 emits green light. The second light emitting stack 220 may include at least one selected from among GaN, InGaN, AlGaN, InGaN, GaP, AlGaInP, and AlGaP, without being limited thereto.

The third light emitting stack 230 may emit light having the shortest peak wavelength. The third light emitting stack 230 may emit blue light. For example, the third light emitting stack 230 may include semiconductor materials, such as GaN, InGaN, ZnSe, and the like, which emit blue light, without being limited thereto. It should be understood that the colors of light emitted from the semiconductor layer stacks are not limited thereto and various combinations of semiconductor layer stacks may be used.

The third light emitting stack 230 is disposed on the first substrate S. The first substrate S may be a substrate, for example, a sapphire substrate, which allows epitaxial growth of the third light emitting stack 230, for example, a stack of semiconductor layers emitting blue light. However, the substrate according to the present disclosure is not limited to the sapphire substrate and may include various transparent insulating materials. For example, the first substrate S may include glass, quartz, silicone, an organic polymer, or an organic-inorganic complex material, and may be, for example, silicon carbide (SiC), gallium nitride (GaN), indium gallium nitride (InGaN), aluminum gallium nitride (AlGaN), aluminum nitride (AlN), gallium oxide (Ga₂O₃), or a silicone substrate.

Although not shown in the drawings, the first substrate S may have a roughness on an upper surface thereof, and may be, for example, a patterned sapphire substrate. The roughness formed on the upper surface of the first substrate S can improve efficiency in extraction of light generated from the third light emitting stack 230 adjoining the first substrate S. In another exemplary embodiment, the first substrate S may be removed.

FIG. 10B is a view of the first light emitting stack 210 before the first light emitting stack 210 is bonded to the second light emitting stack 220 and the third light emitting stack 230. According to the exemplary embodiment, among the multiple light emitting stacks, the first light emitting stack 210 emits light having the longest wavelength and may be, for example, semiconductor layers emitting red light. Accordingly, the second substrate G may be a growth substrate formed of a different material than the first substrate S. For example, the second substrate G may be a GaAs substrate, without being limited thereto.

In addition, before the second and third light emitting stacks 220, 230 are bonded to each other, lower contact layers 242, 243 may be disposed on the second semiconductor layers 223, 233 of the second light emitting stack 220 and the third light emitting stack 230. A second bonding layer 252 may be interposed between the lower contact layers 242, 243 to bond the second light emitting stack 220 to the third light emitting stack 230. The second bonding layer 252 may include a non-conductive material that transmits light. For example, the second bonding layer 252 may include an optically clear adhesive (OCA), more specifically epoxy, polyimide, SU8, spin-on-glass (SOG), and benzocyclobutene (BCB), without being limited thereto.

In addition, although not shown in the drawings, a bonding reinforcement layer may be further interposed between the second light emitting stack 220 and the second bonding layer 252. For example, the bonding reinforcement layer may be disposed between the second bonding layer 252 and the second lower contact layer 242 to bond the second bonding layer 252 to the second lower contact layer 242. The bonding reinforcement layer can prevent the second light emitting stack 220 from being peeled off of the second bonding layer 252 in a process entailing rapid change in stress, such as a laser lift-off process and the like, while preventing breakage of the second light emitting stack. The bonding reinforcement layer may be formed of, for example, a silicon oxide layer, without being limited thereto.

For the same reasons, the bonding reinforcement layer may be further interposed between the second bonding layer 252 and the third light emitting stack 230, more specifically between the second bonding layer 252 and the third lower contact layer 243. In addition, the bonding reinforcement layer may have a smaller thickness than the second and third lower contact layers 242, 243. For example, the bonding reinforcement layer may have a thickness of about 100 nm.

Further, a roughness R may be formed on the upper surface of the first conductivity type semiconductor layer 221 of the second light emitting stack 220. The roughness R may have various shapes and sizes. For example, the roughness R may be formed by pattering in various shapes, for example, a wave shape, an embossed shape, a zigzag shape, and the like. By forming the roughness R on the first conductivity type semiconductor layer 221, it is possible to reduce probability of reflection of light into the first conductivity type semiconductor layer due to total reflection of light upon emission of light to the outside. Accordingly, the roughness can improve luminous efficacy by allowing efficient extraction of light from the semiconductor layer. However, the roughness R is not necessary and the upper surface of the first conductivity type semiconductor layer 221 may have a flat surface.

The growth substrate G of the first light emitting stack 210, that is, the second substrate G, is removed and, like the second bonding layer 252, a first bonding layer 251 is disposed under the first lower contact layer 241 of the first light emitting stack 220 to bond the first light emitting stack 210 to the second and third light emitting stacks 220, 230. As the second substrate G is removed, the first conductivity type semiconductor layer 211 of the first light emitting stack 210 disposed under the second substrate G may be exposed. A roughness R' may be formed in an exposed region on the first conductivity type semiconductor layer 211. The roughness R' may have various shapes and sizes. For example, the roughness R' may be formed by pattering in various shapes, for example, a wave shape, an embossed shape, a zigzag shape, and the like, and may have a regular shape or an irregular shape.

Referring again to FIG. 10A, by forming the roughnesses R, R' on the first conductivity type semiconductor layer 211 of the first light emitting stack 210 and on the first conductivity type semiconductor layer 221 of the second light emitting stack 220, it is possible to reduce the probability of reflection of light into the first conductivity type semiconductor layer due to total reflection of light upon emission of light to the outside. Accordingly, the roughnesses can improve luminous efficacy by allowing efficient emission of light from the semiconductor layers.

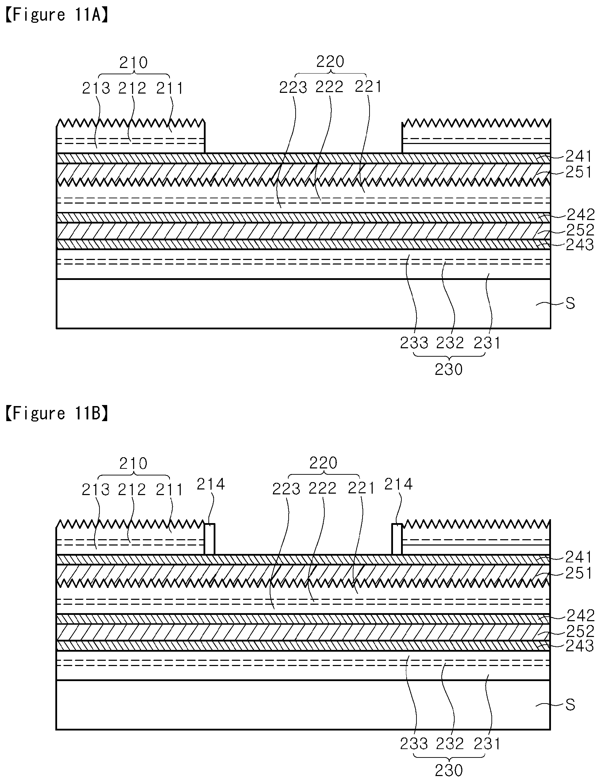

Referring to FIG. 11A, the first light emitting stack 210 may be partially removed by etching and the like. As the first light emitting stack 210 is partially removed, the first lower contact layer 241 may be exposed through a removed region of the first light emitting stack 210. However, it should be understood that the present disclosure is not limited to removal of only the first light emitting stack 210 and the first lower contact layer 241 may also be removed together with the first bonding layer 251 disposed under the first lower contact layer 241. A removed region of the first light emitting stack 210 may be a central region of the first light emitting stack 210, without being limited thereto. Alternatively, the removed region of the first light emitting stack 210 may be placed at one side to adjust viewing angle or luminous intensity.

Although not shown in the drawings, a roughness may be formed on the exposed surface of the first lower contact layer 241. The roughness may have various shapes and sizes. For example, the roughness may be formed by pattering in various shapes, for example, a wave shape, an embossed shape, a zigzag shape, and the like, and may have a regular shape or an irregular shape. By forming the roughness on the exposed surface of the first lower contact layer, it is possible to improve luminous efficacy through efficient extraction of light.

The first lower contact layer 241 may include a transparent conductive material allowing transmission of light. The lower contact layer is disposed on one surface of each of the first, second and third light emitting stacks 210, 220, 230. For example, the first, second and third lower contact layers 241, 242, 243 may include a transparent conductive oxide, for example, SnO, InO₂, ZnO, ITO, ITZO, and the like, without being limited thereto. Alternatively, the lower contact layer may be optionally omitted. Further, the first lower contact layer 241 may have a thinner thickness than the second and third lower contact layers 242, 243. For example, the first lower contact layer 241 may have a thickness of about 240 nm and the second and third lower contact layers 242, 243 may have a thickness of about 300 nm. Further, each of the lower contact layers may optionally include a roughness to improve light extraction efficiency.

Referring to FIG. 11B, as an insulating layer, a reflective layer 214 may be formed in at least some region on a side surface of the first light emitting stack 210 and may include a light reflective material. For example, the reflective layer 214 may include various organic or inorganic insulating materials, such as SiO₂, SiNₓ, Al₂O₃, TiO₂, and the like, and may include a distributed Bragg reflector (DBR). For example, the reflective layer 214 may have a single layer structure or a multilayer structure in which two or more insulating layers having different indexes of refraction are formed. The materials for the reflective layer are not limited thereto and any insulating material capable of reflecting light may be used as the materials for the reflective layer. In other words, the reflective layer 214 can improve luminous efficacy by reflecting light, which is emitted from the first light emitting stack 210 and travels in a lateral direction, such that the light can be extracted in a light emission direction, that is, in an upward direction, instead of spreading in the lateral direction.

Although not shown in the drawings, the side surface of the first light emitting stack 210 may be a slanted surface inclined at a predetermined angle. By forming the slanted side surface of the first light emitting stack 210 to which the reflective layer 214 is applied, the reflective layer 214 can be deposited without generation of cracks, thereby improving reliability and product characteristics.

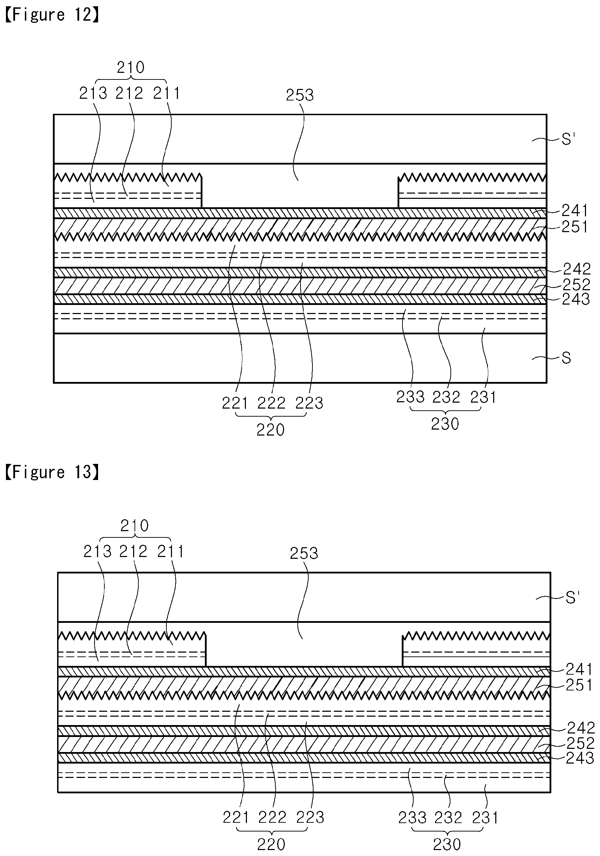

Referring to FIG. 12 and FIG. 13, a third bonding layer 253 may be disposed to fill a space formed by partial removal of the first light emitting stack 210, in other words, a lower space of the second light emitting stack 220 and the third light emitting stack 230 while covering the side surface and the upper surface of the first light emitting stack 210. The third bonding layer 253 can bond a third substrate S' to the upper surface of the first light emitting stack 210, whereby the third substrate S' can be disposed at the uppermost portion in the light emission direction. Further, the third bonding layer 253 may allow a post-process to be performed after removal of the first substrate S from the third light emitting stack 230.

In addition, the third bonding layer 253 may be formed of a light transmitting material to allow light emitted from the first, second and third light emitting stacks 210, 220, 230 to be emitted towards the third substrate S'. Further, the third bonding layer 253 may exhibit bonding properties to bond the first light emitting stack 210 to the third substrate S' while exhibiting insulating properties. The first and second bonding layers 251, 252 also have such properties and thus the third bonding layer 253 may be formed of the same material as the first and second bonding layers 251, 252. However, it should be understood that other implementations are possible and the first, second and third bonding layers 251, 252, 253 may be formed of different materials.

A region of the third bonding layer 253 overlapping the first light emitting stack 210 may have a different thickness from a region of the third bonding layer 253 not overlapping the first light emitting stack 210. Preferably, the region of the third bonding layer 253 overlapping the first light emitting stack 210 may have a thinner thickness and the region of the third bonding layer 253 not overlapping the first light emitting stack 210 may have a thicker thickness. Accordingly, since light generated from the first light emitting stack 210 can be effectively emitted through the third bonding layer 253 while being blocked in some region of the third bonding layer 253 having a thicker thickness, the third bonding layer 253 can prevent light emitted from the second and third light emitting stacks 220, 230 from entering and being interfered and absorbed by the first light emitting stack 210.

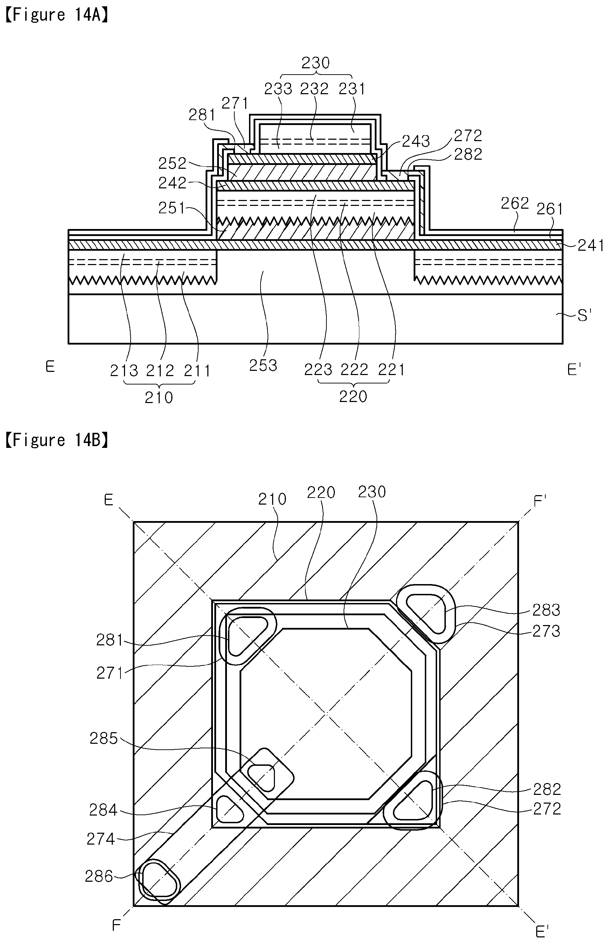

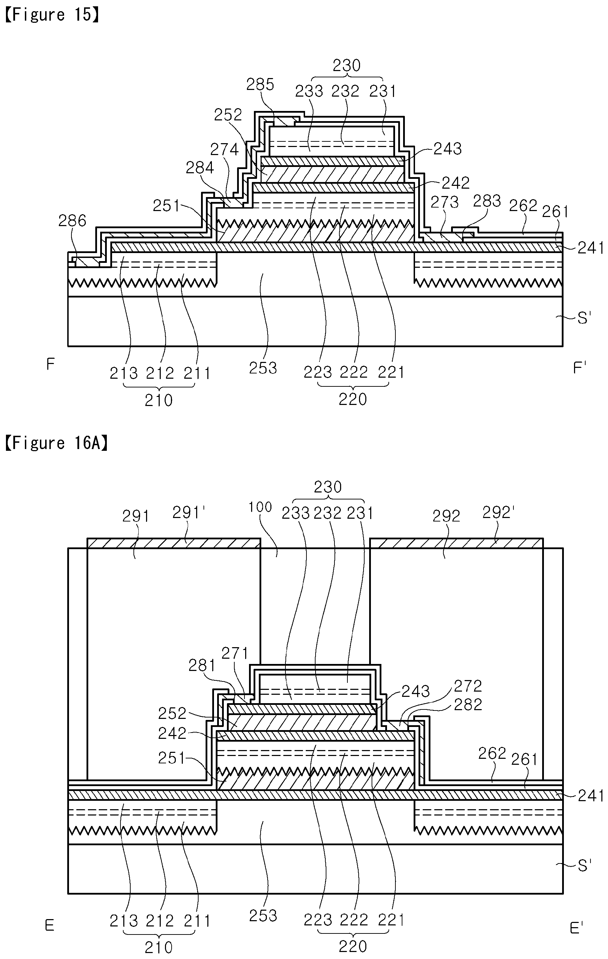

FIG. 14A and FIG. 15 are views obtained by rotating FIG. 13 by 180 degrees such that, among the first, second and third light emitting stacks 210, 220, 230, the first light emitting stack 210 is placed under the second and third light emitting stacks 220, 230, that is, such that the third substrate S' corresponding to the light emission direction is placed at the lowermost side and the third light emitting stack 230 is placed at the uppermost side. Accordingly, referring to FIG. 14A and FIG. 15, the light emission direction corresponds to a downward direction, that is, a direction of the third substrate S'. Further, first to fourth electrode pads 271, 272, 273, 274 may be formed through etching of the first, second and third light emitting stacks 210, 220, 230, deposition and the like to supply electricity to a stack type light emitting diode, that is, to the first, second and third light emitting stacks 210, 220, 230.

Further, as the second and third light emitting stacks 220, 230 are subjected to etching, the first lower contact layer 241 disposed on at least part of the first light emitting stack 210, more specifically on one surface of the first light emitting stack 210, may be exposed.

Further, in top plan view of the stack type light emitting diode, the first light emitting stack 210 may be disposed so as not to overlap the second and third light emitting stacks 220, 230. In other words, the first light emitting stack 210 may include a region not overlapping the second and third light emitting stacks 220, 230. That is, at least some fraction of light emitted from the second light emitting stack 220 or the third light emitting stack 230 may be discharged outside without passing through the first light emitting stack 210. In other words, light generated from the second light emitting stack 220 may be discharged after passing through the side surface of the side surface of the first light emitting stack 210 and a region of the third bonding layer 253 disposed on the second light emitting stack 220. Thus, as the first light emitting stack 210 is disposed so as not to overlap the third light emitting stack 230, a traveling path along which light emitted from the light emitting stacks is discharged outside, that is, the number of light emitting stacks through which light passes, can be efficiently reduced to improve light extraction efficiency. Further, a light emitting area can be maximized by using the area of the stack type light emitting diode as much as possible, thereby improving luminous efficacy.

Further, in top plan view of the stack type light emitting diode, the second light emitting stack 220 and the third light emitting stack 230 may be disposed to overlap each other in at least some regions thereof.

Although not shown in the drawings, in top plan view of a stack type light emitting diode according to another exemplary view, the first light emitting stack 210 may partially overlap the second light emitting stack 220 depending upon the degree of etching the second and third light emitting stacks 220, 230. In a further exemplary embodiment, the first, second and third light emitting stacks 210, 220, 230 may be disposed to overlap each other in at least some regions thereof or may be disposed so as not to overlap each other in at least some regions thereof.

The first light emitting stack 210 may at least partially overlap the second light emitting stack in a region near an outer periphery thereof. Accordingly, an overlapping region can be minimized to secure effective light extraction.

FIG. 14B is a plan view obtained from FIG. 14A and FIG. 15. That is, FIG. 14A is a cross-sectional view taken along line E-E' of FIG. 14B and FIG. 15 is a cross-sectional view taken along line F-F' of FIG. 14B.

Referring to FIG. 14B, in one exemplary embodiment, at least some region of the first light emitting stack 210 may be exposed instead of overlapping the second and third light emitting stacks 220, 230 in plan view. The first light emitting stack 210 may be disposed in an outer peripheral region of the light emitting diode, in which the first, second and third light emitting stacks 210, 220, 230 are stacked one above another, and may be removed in the central region thereof, as described above, to expose at least some regions of the second light emitting stack 220 and the third light emitting stack 230. In other words, the first light emitting stack 210 may be disposed in the outer peripheral region to surround the second light emitting stack 220 and the third light emitting stack 230 and the second light emitting stack 220 and the third light emitting stack 230 may be placed closer to the central region than the first light emitting stack 210, when viewed in top plan view. More specifically, the first light emitting stack 210 may be disposed so as not to pass through the central region of the stack type light emitting diode and the second and third light emitting stacks 220, 230 may be disposed to pass through the central region of the stack type light emitting diode. Accordingly, the area of the first light emitting stack 210 can be secured as large as possible while minimizing an area where light emitted from the first light emitting stack 210 passes through other light emitting stacks, thereby improving luminous efficacy.

According to an exemplary embodiment, the area occupied by the first light emitting stack 210, that is, the area of the outer peripheral region of the stack type light emitting diode, may be larger than the area occupied by the second light emitting stack 220 and the third light emitting stack 230, that is, the area of the central region of the stack type light emitting diode. In other words, a light emitting stack having a relatively low intensity of light, for example, the first light emitting stack 210 having lower intensity of light than the second and third light emitting stacks 220, 230, may be formed to have the largest light emitting area, whereby the intensity of light can be efficiently adjusted through reduction in difference between quantities of light emitted from the first, second and third light emitting stacks 210, 220, 230 so as to improve luminous efficacy as much as possible.

For example, a full color display device may be implemented by stacking light emitting diodes that emit red, green and blue colors to display a trichromatic pixel. Here, a light emitting stack having an insufficient intensity of light is provided as the first light emitting stack 210 to maximize the light emitting area, thereby improving the intensity of light. As such, the stack type light emitting diode according to this exemplary embodiment allows efficient adjustment in intensity of light through reduction in difference in intensity of light between the red, green and blue light emitting stacks, thereby improving luminous efficacy and product quality.

Although not shown in the drawings, according to another exemplary embodiment, the area occupied by the first light emitting stack 210, that is, the area of the outer peripheral region of the stack type light emitting diode, may be smaller than the area occupied by the second light emitting stack 220 and the third light emitting stack 230. In this exemplary embodiment, the intensity of light emitted from the second light emitting stack 220 and the third light emitting stack 230 may be lower than the intensity of light emitted from the first light emitting stack 210. In other words, when the first light emitting stack 210 provides the highest intensity of light, the first light emitting stack 210 may be disposed in the outer peripheral region with the smallest area to minimize a difference between the intensities of light emitted from the first, second and third light emitting stacks 210, 220, 230, thereby effectively improving luminous efficacy. However, it should be understood that other implementations are possible and the area of the outer peripheral area of the light emitting diode may be similar to the area of the central region thereof. For example, when the first, second and third light emitting stacks 210, 220, 230 emit a similar intensity of light, the light emitting stacks may be formed to have a similar light emitting area.

Referring again to FIG. 5B, the central region of the stack type light emitting diode, that is, the shape of the second and third light emitting stack 220, 230, is not limited to a particular shape, and may have various partially angled shapes, that is, polygonal shapes, for example, a rectangular shape, a triangular shape, a hexagonal shape, an octagonal shape, a rhombus shape, and the like, or various partially curved shapes, for example, a circular shape, an elliptical shape, and the like.

Referring again to FIG. 11A, according to another exemplary embodiment, the second light emitting stack 220 may also be removed together with the first light emitting stack 210 upon removal of a portion or the central region of the first light emitting stack 210. The second light emitting stack 220 may also be removed to expose the second lower contact layer 242 in some region or the central region of the first light emitting stack 210. Further, the third bonding layer 253 may be disposed to cover some region or central region of the first light emitting stack 210, that is, a space formed by removing the first and second light emitting stacks 210, 220, and the side surfaces of the first and second light emitting stacks 210, 220 while covering the upper surface of the first light emitting stack 210 to bond the third substrate S' to the first light emitting stack 210.

In addition, when the light emitting structure is rotated by 180 degrees after the first substrate S is removed, the third light emitting stack 230 may be placed at an upper side. The second lower contact layer 242 disposed on at least part of the second light emitting stack 220, more specifically on one surface of the second light emitting stack 220, may be exposed at the outer periphery of the stacked semiconductor layers through etching of the first, second and third light emitting stacks 210, 220, 230, deposition, and the like. As a result, the third light emitting stack 230 is disposed at the uppermost side of the central region of the stack type light emitting diode, and the second light emitting stack 220 and the first light emitting stack 210 may be sequentially stacked in the outer peripheral region surrounding the third light emitting stack 230.

Further, in top plan view of the stack type light emitting diode, the third light emitting stack 230 may be disposed to have at least some region not overlapping the first light emitting stack 210. Since the third light emitting stack 230 is disposed to have at least some region not overlapping the first light emitting stack 210, the traveling path along which light emitted from the light emitting stacks is discharged outside, that is, the number of light emitting stacks through which light passes, can be efficiently reduced while minimizing the probability that light is lost inside the semiconductor layers, thereby efficiently improving light extraction efficiency.

Further, the first light emitting stack 210 and the second light emitting stack 220 may be disposed to overlap each other in at least some regions thereof when viewed in plan view. Further, the first, second and third light emitting stacks 210, 220, 230 may be disposed to overlap each other in at least some regions thereof or may be disposed so as not to overlap each other in at least some regions thereof.

Further, in top plan view of the stack type light emitting diode, the area occupied by the third light emitting stack 230 may be smaller or larger than the area occupied by the first and second light emitting stacks 210, 220. In other words, the outer peripheral region of the stack type light emitting diode may have a smaller or larger area than the central region thereof. Here, the stack type light emitting diode can improve luminous efficacy by selectively maximizing the light emitting area of a light emitting stack having insufficient intensity of light among the first, second and third light emitting stacks 210, 220, 230. Further, the shape of the third light emitting stack 230, that is, the shape of the central region of the stack type light emitting diode, may have various shapes without being limited to a particular shape.

Referring to FIG. 16A to FIG. 17, in the course of stacking and electrically connecting the first, second and third light emitting stacks 210, 220, 230, the side surfaces of the first, second and third light emitting stacks 210, 220, 230 may be formed in a stepped shape. Although not shown in the drawings, the stepped side surfaces of the first, second and third light emitting stacks 210, 220, 230 may include various shapes. For example, the side surfaces of the first, second and third light emitting stacks 210, 220, 230 may include slanted side surfaces inclined at a predetermined angle. By forming the slanted side surfaces of the first, second and third light emitting stacks 210, 220, 230, the first to fourth electrode pads 271, 272, 273, 274 and first and second insulating layers 261, 262 can be deposited on the side surfaces of the light emitting stacks without generation of cracks, thereby improving reliability and product characteristics.

The first and second insulating layers 261, 262 may be disposed to insulate the side surfaces of the first, second and third light emitting stacks 210, 220, 230 and the first, second and third lower contact layers 241, 242, 243 from the first to fourth electrode pads 271, 272, 273, 274 and to insulate the first to fourth electrode pads 271, 272, 273, 274 from the first to fourth connection electrodes 271, 272, 273, 274.

Further, at least one of the first and second insulating layers 261, 262 may include a reflective material. For example, the insulating layers may include various organic or inorganic materials, such as SiO₂, SiNₓ, Al₂O₃, TiO₂, and the like, and at least one of the insulating layers may include a distributed Bragg reflector (DBR). For example, the insulating layers may have a single layer structure or a multilayer structure composed of at least two insulating layers having different indexes of refraction, without being limited thereto. It should be understood that the first and second insulating layers may be formed of any material capable of improving luminous efficacy through emission of light in the direction of the third substrate S'.

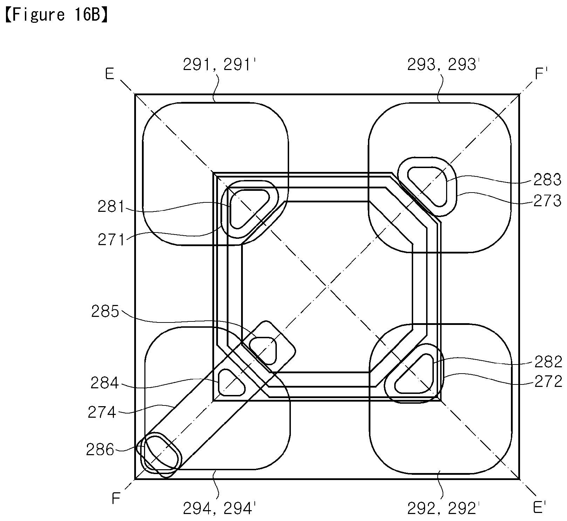

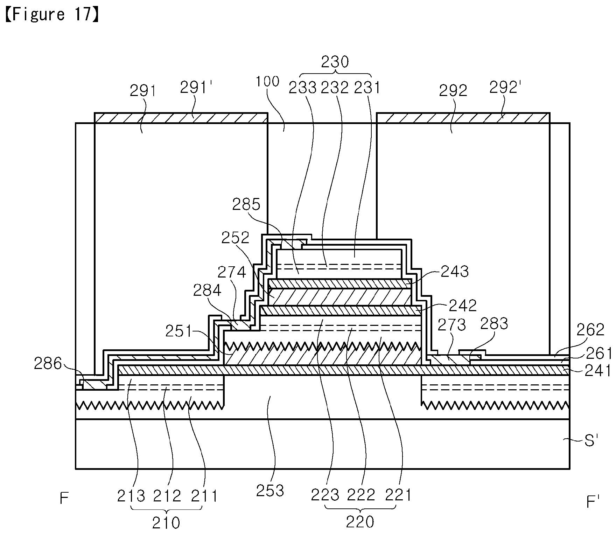

FIG. 16B is a plan view obtained from FIG. 16A and FIG. 17. That is, FIG. 16A is a cross-sectional view taken along line E-E' of FIG. 16B and FIG. 17 is a cross-sectional view taken along line F-F' of FIG. 16B. Referring to FIG. 16B, which is a plan view taken in an electrode bonding direction instead of the light emission direction, that is, the direction of the third substrate S', the first, second and third light emitting stacks 210, 220, 230 may be electrically connected to the outside by the connection electrodes 291, 292, 293, 294 and bonding metal layers 291', 292', 293', 294'. Here, the first electrode pad 271 is a P-electrode pad of the first light emitting stack 210, the second electrode pad 272 is a P-electrode pad of the second light emitting stack 220, and the third electrode pad 273 is a P-electrode pad of the third light emitting stack 230. In addition, the fourth electrode pad 274 is a common N-electrode pad connected to the first, second and third light emitting stacks 210, 220, 230. However, it should be understood that other implementations are possible. Alternatively, the first electrode pad 271 may be an N-electrode pad of the first light emitting stack 210, the second electrode pad 272 may be an N-electrode pad of the second light emitting stack 220, the third electrode pad 273 may be an N-electrode pad of the third light emitting stack 230, and the fourth electrode pad 274 may be a common P-electrode pad connected to the first, second and third light emitting stacks 210, 220, 230.

Further, the pixel device may further include a protective layer 100 that fills spaces between the first to fourth connection electrodes 291, 292, 293, 294 while covering side surfaces of the first to fourth connection electrodes 291, 292, 293, 294. The protective layer 100 may be formed of an insulating material that insulates the first to fourth connection electrodes 291, 292, 293, 294 from one another. In addition, the protective layer 100 may include a material, which does not absorb light and can reflect light, to improve light extraction efficiency by reflecting light in the direction of the third substrate S' corresponding to the light emission direction.

Although not shown in the drawings, according to an exemplary embodiment, the pixel device may further include a contact electrode on the first conductivity type semiconductor layer 231 of the third light emitting stack 230. The contact electrode may form ohmic contact with the first conductivity type semiconductor layer 231. A portion of the first conductivity type semiconductor layer 231 may be recessed by patterning and the contact electrode may be disposed in a recessed region of the first conductivity type semiconductor layer 231 to improve ohmic contact efficiency. The contact electrode may have a single layer structure or a multi layer structure, and may include Al, Ti, Cr, Ni, Au, Ag, Sn, W, Cu, or alloys thereof, for example, Au-Te alloys or Au-Ge alloys, without being limited thereto. In addition, for example, the contact electrode may have a thickness of about 100 nm and may include a meal having high reflectance in order to improve an effect of emitting light in a downward direction towards the third substrate S' corresponding to the light emission direction. In other words, a metal reflective layer having high reflectance may be disposed on the first conductivity type semiconductor layer 231 of the third light emitting stack 230 disposed at the lowermost side in the light emission direction. Accordingly, the metal reflective layer can improve light extraction efficiency through effective discharge of light by reflecting light, which travels towards the first conductivity type semiconductor layer 231 of the third light emitting stack 230, towards the third substrate S', that is, in the light emission direction.

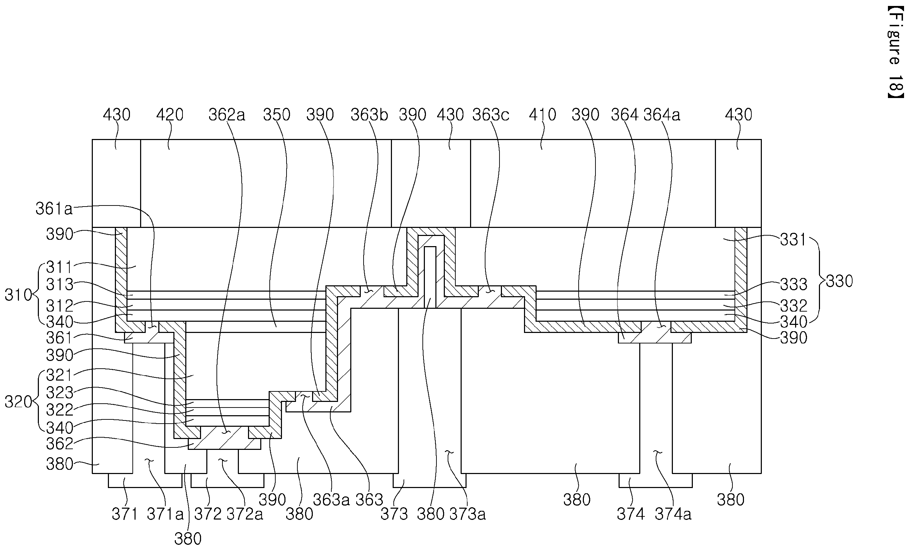

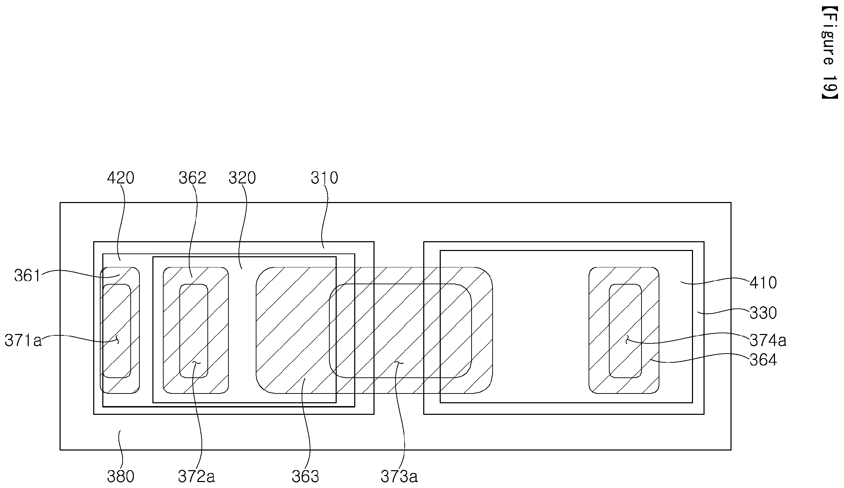

FIG. 18 is a schematic cross-sectional view of a pixel device according to yet another exemplary embodiment and FIG. 19 is a schematic plan view showing relative positions of some components shown in FIG. 18. Descriptions of the same components as the above embodiments will be omitted.

Referring to FIG. 18 and FIG. 19, the pixel device includes a first light emitting structure 310, a second light emitting structure 320 disposed under the first light emitting structure 310, a third light emitting structure 330 disposed horizontally side-by-side to the first light emitting structure 310, and a first molding layer 410 disposed on the third light emitting structure 330.

The first light emitting structure 310 and the third light emitting structure 330 may have substantially coplanar upper surfaces and may be disposed to have a height difference of 50 µm or less between the upper surfaces thereof. Accordingly, it is possible to prevent generation of deviation in viewing angle due to the height difference when observed from outside. The first light emitting structure 310 and the third light emitting structure 330 may be grown on the same growth substrate and may be disposed on a single substrate. The growth substrate may be removed or may remain to allow light generated from the first to third light emitting structures 310, 320, 330 to be discharged outside through the growth substrate.

The first light emitting structure 310 includes a first conductivity type semiconductor layer 311, a second conductivity type semiconductor layer 312, and an active layer 313; the second light emitting structure 320 includes a first conductivity type semiconductor layer 321, a second conductivity type semiconductor layer 322, and an active layer 323; and the third light emitting structure 330 includes a first conductivity type semiconductor layer 331, a second conductivity type semiconductor layer 332, and an active layer 333. The first conductivity type semiconductor layer 311 may include a light spreading surface having a roughness to improve visibility by scattering light incident on the light emitting structure while enabling effective extraction of light generated from the active layer 323.

A second molding layer 420 may be disposed on the first light emitting structure 310 and the first molding layer 410 may be formed to substantially the same height as the second molding layer 420. A height difference between the first molding layer 410 and the second molding layer 420 may be 50 µm or less. Accordingly, it is possible to prevent generation of deviation in viewing angle due to the height difference when observed from outside.

The first molding layer 410 may include a wavelength conversion material. That is, light emitted from the third light emitting structure 330 may excite the wavelength conversion material while passing through the first molding layer 410. Light subjected to wavelength conversion by the first molding layer 410 may have a narrow peak wavelength with a full width at half maximum(FWHM) of 50 nm or less, preferably 20 nm or less.

As such, the light having emitted from the first molding layer 410 has a peak wavelength with a narrow full width at half maximum(FWHM), thereby realizing high color clarity. The wavelength conversion material may include phosphors and/or quantum dots. The wavelength conversion material may be distributed in a transparent resin. The wavelength conversion material may have a circular shape, an elongated bar shape or an amorphous shape.

The wavelength conversion material may be garnet-based phosphors represented by (A, B, C)₈₋ₓO₁₂:Ce. Here, A may include at least one element selected from among Y, Lu, Tb, Gd, La, and Sm. C may include at least one element selected from among Al, Si, Ga, and In. B may be one of the elements of A or the elements of B. Alternatively, B may be the same element as A or B. When B is one of the elements of C, the sum of moles of B and C may be greater than 5 and less than 7. When B is one of the elements of A, the sum of moles of A and B may be greater than 1 and less than 5. X may be greater than 0.001 and less than or equal to 0.5.

The phosphors may include at least one type of phosphor selected from among garnet-based phosphors, silicate-based phosphors, sulfide-based phosphors, oxynitride-based phosphors, nitride-based phosphors, and aluminate-based phosphors. For example, the garnets-based phosphors may be represented by A₃B₅O₁₂:C. Here, A may include at least one element selected from among Y, Lu, Tb, and Gd. B may include at least one element selected from among Al, Ga, Si, and In. In addition, C may include at least one element selected from among Ce, Nd, Er, and Th. The sulfide-based phosphors may include red phosphors of (Ca,Sr)S:Eu. The nitride-based phosphors may include red phosphors of CaAlSiN₃:Eu, red phosphors of (Sr, Ca)AlSiN₃:Eu, red phosphors of Sr₂Si₅N₈:Eu, and the like.

The phosphors may include fluoride phosphors. The fluoride phosphors may include phosphors represented by A₂SiF₆:Mn. Here, A may be an alkali metal element including at least potassium. For example, The fluoride phosphors may include red phosphors of K₂SiF₆:Mn.

In addition, the phosphors may include manganese-containing fluoride phosphors of A₂[M₁₋ₐMnₐF₆]. Here, A may be at least one element selected from the group consisting of K, Li, Na, Rb, Cs and NH₄. M may be at least one element selected from the group consisting of group IV elements and group XIV elements. a may satisfy a relation: 0<a<0.2.

The manganese-containing fluoride phosphors (hereinafter referred to as KSF phosphors) are prepared by doping tetravalent manganese ions and may emit red light having a wavelength of about 630 nm. In addition, the manganese-containing fluoride phosphors may emit colors at two peak wavelengths, thereby providing an advantage of high color reproducibility.

Further, the manganese-containing fluoride phosphors may include red phosphors represented by (A₄₋ₐBₐ)_{m/2+n/2}X₂ₘ[MX₄O₂]ₙ based on an oxiodohalide host lattice. Here, A may be selected from the group consisting of hydrogen (H), deuterium (D), or mixtures thereof. B may be selected from the group consisting of Li, Na, K, Rb, Cs, NH₄, ND₄, NR₄ or mixtures thereof. R may be an alkyl or aryl radical. X may be selected from the group consisting of F, Cl or mixtures thereof. M may be selected from the group consisting of Cr, Mo, W, Re or mixtures thereof. a, m and n satisfy relations: 0≤a≤ 4, 0<m≤10, and 1≤n≤10.

When the wavelength conversion material includes quantum dots, the first molding layer 410 may be provided in any form of a sheet and a resin. When the quantum dots include group II-VI compounds, the quantum dots may include Cd and Se. In addition, when the quantum dots include group III-V compounds, the quantum dots may include In and P.

The quantum dots may include a core comprising group II-VI compounds or group III-V compounds and a protective layer surrounding the core to protect the core. Here, the protective layer may include a shell and a ligand. The protective layer may include Zn, S, and the like.

The quantum dots may generate light from the cores thereof. As the size of the quantum dots decreases, the band gap of the quantum dots increases, thereby enabling emission of light having a short wavelength. In addition, as the size of the quantum dots increases, the band gap of the quantum dots decreases, thereby enabling emission of light having a long wavelength. That is, the wavelength of light emitted from the quantum dots may be shortened with decreasing size of the quantum dots and may be increased with increasing size of the quantum dots. As such, the wavelength of light emitted from the quantum dots may be determined depending on the size of the cores or the size of the quantum dots. For example, the quantum dots or the cores may have a diameter of about 10 nm or less, preferably about 2 nm to 5 nm.

In order to reduce the full width of the peak wavelength of light having passed through the first molding layer 410, a band pass filter may be disposed on the first molding layer 410.

Unlike the first molding layer 410, the second molding layer 420 may transmit light emitted from the first or second light emitting structure 310 or 320 without wavelength conversion of the light.

The first light emitting structure 310 and the third light emitting structure 330 may emit the same color-based light, and the second light emitting structure 320 may emit different color-based light than the first light emitting structure 310. Here, although the first light emitting structure 310 and the third light emitting structure 330 emit the same color-based light, the first light emitting structure 310 and the third light emitting structure 330 may emit light having different peak wavelengths. A difference between the peak wavelengths of light generated from the first light emitting structure 310 and the third light emitting structure 330 may be less than 5 nm. The peak wavelength of light generated from the second light emitting structure 320 may be longer than the peak wavelength of light generated from the first light emitting structure 310 by 50 nm to 150 nm.

The peak wavelength of light generated from the first light emitting structure 310 may have a first full width at half maximum(FWHM) F1 in the range of 10 nm to 25 nm. The peak wavelength of light generated from the second light emitting structure 320 may have a second FWHM F2 in the range of 20 nm to 40 nm. The peak wavelength of light generated from the third light emitting structure 330 may have a third FWHM F3 in the range of 10 nm to 25 nm, and the peak wavelength of light generated from the first molding layer 410 may have a fourth FWHM F4 in the range of 3 nm to 50 nm. The first FWHM F1 may be smaller than the second FWHM F2. The third FWHM F3 may be smaller than the second FWHM F2. The fourth FWHM F4 may be smaller than the second FWHM F2. Preferably, the first to fourth full half widths at half maximum have a relation: fourth FWHM F4 < first FWHM F1 < second FWHM F2. Alternatively, the first to fourth full half widths at half maximum may have a relation: fourth FWHM F4 < third FWHM F3 < second FWHM F2. As a result, a clearer display can be implemented.

By way of example, both the first light emitting structure 310 and the third light emitting structure 330 may have a peak wavelength in the range of 430 nm to 470 nm and may emit blue-based light. The second light emitting structure 320 may have a peak wavelength in the range of 520 nm to 580 nm and may emit green-based light. Further, light emitted from the third light emitting structure 330 may be converted into red-based light having a peak wavelength in the range of 600 nm to 680 nm by the first molding layer 410 before the light is discharged outside.

In general, a chip emitting red-based light has lower efficiency than a chip emitting blue or green-based light. Accordingly, in order to adjust a light ratio of red, green and blue light, a greater quantity of electric current is supplied to the chip emitting red-based light whereby a large quantity of heat is generated from the chip emitting red-based light, thereby making it difficult to control the chips due to increase in deviation of electric current between the chips.

According to this embodiment, the third light emitting structure 330 emits blue-based light and the first molding layer 410 performs wavelength conversion of light emitted from the third light emitting structure 330 into red-based light, thereby securing better efficiency than the structure in which the third light emitting structure 330 emits red-based light.

In addition, although stacking of multiple chips in the vertical direction has an advantage in minimization of a light emitting device as compared with stacking of the multiple chips in the horizontal direction, there is a problem in that light emitted from a lower chip is absorbed by an upper chip.

According to this embodiment, the first light emitting structure 310 and the second light emitting structure 320 are stacked one above another and the third light emitting structure 330 is disposed horizontally side-by-side thereto, thereby securing an advantage in minimization of the light emitting device without absorption of light emitted from the third light emitting structure 330, as compared with a structure in which all chips are horizontally arranged side by side.

A third molding layer 430 may be formed in a region where the first molding layer 410 or the second molding layer 420 is not formed. The third molding layer 430 may act as a partition wall that prevents the first molding layer 410 and the second molding layer 420, which have a liquid phase in manufacture of the light emitting device, from flowing before the first and second molding layers are cured. When the first molding layer 410 and the second molding layer 420 are provided in a sheet form, a curing process is not required and the third molding layer 430 may be omitted. In addition, the third molding layer 430 may contain a light blocking material to prevent light passing through the first molding layer 410 or the second molding layer 420 from leaking out through side surfaces thereof. The third molding layer 430 may divide a window region.

The third molding layer 430 may include at least some region at least partially overlapping a region between the first light emitting structure 310 and the second light emitting structure 320. Alternatively, the third molding layer 430 may include at least some region vertically overlapping a region between the active layer 312 of the first light emitting structure 310 and the active layer 332 of the third light emitting structure 330.

A lower surface of the second molding layer 420 may have a smaller width than the upper surface of the first conductivity type semiconductor layer 311 of the first light emitting structure 310. Accordingly, at least part of the third molding layer 430 may cover a portion of the upper surface of the first conductivity type semiconductor layer 311 of the first light emitting structure 310. The lower surface of the second molding layer 420 may have a smaller width than the upper surface of the first conductivity type semiconductor layer 331 of the third light emitting structure 330. Accordingly, at least part of the third molding layer 430 may cover a portion of the upper surface of the first conductivity type semiconductor layer 331 of the third light emitting structure 330.

Although FIG. 18 shows that the width of the second light emitting structure 320 is narrower than the width of the first light emitting structure 310, it should be understood that other implementations are possible. Alternatively, the first light emitting structure 310 may have the same width as the second light emitting structure 320, or the second light emitting structure 320 may have a greater width than the first light emitting structure 310, as needed. When the same quantity of electric current is supplied, the second light emitting structure 320 may have a different current density than the first light emitting structure 310.

Each of the light emitting structures 310, 320, 330 may have a peak wavelength and a dominant wavelength and a difference between the peak wavelength and the dominant wavelength of the first light emitting structure 310 may be greater than a difference between the peak wavelength and the dominant wavelength of the second light emitting structure 320. Alternatively, a difference between the peak wavelength and the dominant wavelength of the third light emitting structure 330 may be greater than a difference between the peak wavelength and the dominant wavelength of the second light emitting structure 320. The second light emitting structure 320 having the smallest difference between the peak wavelength and the dominant wavelength may be placed near a lower end of the pixel device, thereby enabling stable implementation of colors even when light generated from the second light emitting structure 320 passes other materials or other light emitting structures. The difference between the peak wavelength and the dominant wavelength of the first light emitting structure 310 may be 10 nm or less from the difference between the peak wavelength and the dominant wavelength of the second light emitting structure 320. Accordingly, color deviation of the light emitting devices can be reduced by arranging multiple light emitting structures side by side.

A first cover layer 390 may be disposed to surround the exposed side surfaces and lower surfaces of the first light emitting structure 310, the second light emitting structure 320 and the third light emitting structure 330. The first cover layer 390 may be formed of an insulating material and multiple openings 361a, 362a, 363a, 363b, 363c, 364a may be formed at the lower sides of the first light emitting structure 310, the second light emitting structure 320, and the third light emitting structure 330.

The first cover layer 390 is provided at the lower side thereof with multiple electrode pads 361, 362, 363, 364.

A first electrode pad 361 is electrically connected to the second conductivity type semiconductor layer 312 of the first light emitting structure 310 through a first opening 361a. The first light emitting structure 310 may further include an ohmic layer 340 disposed under the second conductivity type semiconductor layer 312 to secure efficient ohmic contact with the first electrode pad 361.

A second electrode pad 362 is electrically connected to the second conductivity type semiconductor layer 322 of the second light emitting structure 320 through a second opening 362a. The second light emitting structure 320 may further include an ohmic layer 340 disposed under the second conductivity type semiconductor layer 322 to secure efficient ohmic contact with the second electrode pad 362.

A third electrode pad 363 is electrically connected to the second conductivity type semiconductor layer 322 of the second light emitting structure 320 through a third opening 363a, electrically connected to the first conductivity type semiconductor layer 311 of the first light emitting structure 310 through a fourth opening 363b, and electrically connected to the first conductivity type semiconductor layer 311 of the third light emitting structure 330 through a fifth opening 363c. That is, the third electrode pad 363 is commonly connected to the first, second and third light emitting structures 310, 320, 330.

A fourth electrode pad 364 is electrically connected to the second conductivity type semiconductor layer 322 of the third light emitting structure 330 through a sixth opening 364a. The third light emitting structure 330 may further include an ohmic layer 340 disposed under the second conductivity type semiconductor layer 332 to secure efficient ohmic contact with the fourth electrode pad 364.

The first light emitting structure 310 may be bonded to the second light emitting structure 320 by a bonding layer 350. For the first light emitting structure 310 including the ohmic layer 340, the bonding layer 350 is disposed between the ohmic layer 340 of the first light emitting structure 310 and the first conductivity type semiconductor layer 321 of the second light emitting structure 320.

A second cover layer 380 may be disposed to surround the first cover layer 390 and the exposed side surfaces and lower surfaces of the first light emitting structure 310, the second light emitting structure 320 and the third light emitting structure 330. The second cover layer 380 may be formed of an insulating material and multiple openings 371a, 372a, 373a, 374a are formed at lower sides of the multiple electrode pads 361, 362, 363, 364, respectively.

Multiple connection layers 371, 372, 373, 374 may be disposed under the second cover layer 380. A first connection layer 371 may be electrically connected to the first electrode pad 361 through a seventh opening 371a, a second connection layer 372 may be electrically connected to the second electrode pad 362 through an eighth opening 372a, a third connection layer 373 may be electrically connected to the third electrode pad 363 through a ninth opening 373a, and a fourth connection layer 374 may be electrically connected to a fourth electrode pad 364 through a tenth opening 374a.

The third connection layer 373 may be disposed under a region between the first light emitting structure 310 and the third light emitting structure 330. Accordingly, the third connection layer 373 may perpendicularly overlap the third molding layer 430 formed between the first molding layer 410 and the second molding layer 420, and a region between the first light emitting structure 310 and the third light emitting structure 330.

The multiple openings 371a, 372a, 373a, 374a may be formed to different depths and the ninth opening 373a may have the deepest depth. When the ninth opening 373a is formed to the deepest depth, the third connection layer 373 place at the middle among the multiple connection layers 371, 372, 373, 374 may have the highest height to efficiently support the light emitting device.

According to this embodiment, the first conductivity type semiconductor layer 311 of the first light emitting structure 310 is separated from the first conductivity type semiconductor layer 331 of the third light emitting structure 330. Accordingly, the first cover layer 390, the third electrode pad 363 and the second cover layer 380 may be disposed between the first conductivity type semiconductor layer 311 of the first light emitting structure 310 and the first conductivity type semiconductor layer 331 of the third light emitting structure 330.

The upper surfaces of the first light emitting structure 310 and the third light emitting structure 330 may be subjected to texturing. In addition, light transmitting layers having different indexes of refraction may be disposed between the first light emitting structure 310 and the second molding layer 420 and between the third light emitting structure 330 and the first molding layer 410, respectively. The light transmitting layer may be a substrate.

The first to third light emitting structures 310, 320, 330 may be individually operated.

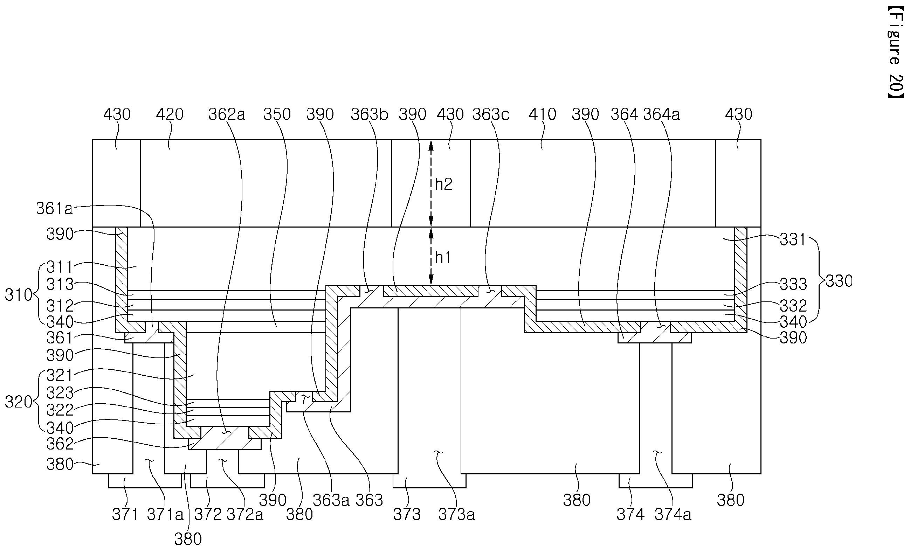

FIG. 20 is a schematic cross-sectional view of a pixel device according to yet another exemplary embodiment. The pixel device according to this exemplary embodiment is distinguished from the pixel device shown in FIG. 19 in that the first conductivity type semiconductor layer 311 of the first light emitting structure 310 is integrally formed with the first conductivity type semiconductor layer 331 of the third light emitting structure 330.

Although the first conductivity type semiconductor layer 311 of the first light emitting structure 310 is integrally formed with the first conductivity type semiconductor layer 331 of the third light emitting structure 330, the first light emitting structure 310 and the third light emitting structure 330 are divided into individual light emitting regions to be individually operated.

The third molding layer 430 disposed between the first molding layer 410 and the second molding layer 420 may be provided at the lower side thereof with a semiconductor connector, which connects the first conductivity type semiconductor layer 311 of the first light emitting structure 310 to the first conductivity type semiconductor layer 331 of the third light emitting structure 330, (hereinafter, "semiconductor connector"), and a height h1 of the semiconductor connector may be lower height than a height h2 of the third molding layer 430 (h1<h2). Accordingly, even when the semiconductor connector connects the first conductivity type semiconductor layer 311 of the first light emitting structure 310 to the first conductivity type semiconductor layer 331 of the third light emitting structure 330, it is possible to prevent light leakage by the semiconductor connector.

The third connection layer 373 may be disposed under the semiconductor connector. Accordingly, the third connection layer 373 may perpendicularly overlap the third molding layer 430 formed between the first molding layer 410 and the second molding layer 420 and the semiconductor connector. Descriptions of the same components as those of the exemplary embodiment shown in FIG. 19 will be omitted.

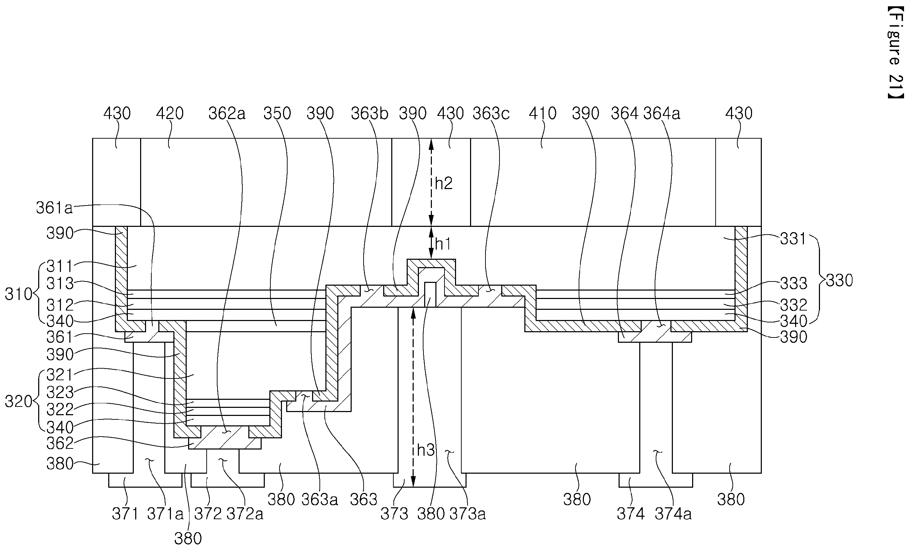

FIG. 21 is a schematic cross-sectional view of a pixel device according to yet another exemplary embodiment. Like the pixel device shown in FIG. 20, the pixel device according to this embodiment has the structure in which the first conductivity type semiconductor layer 311 of the first light emitting structure 310 is integrally formed with the first conductivity type semiconductor layer 331 of the third light emitting structure 330. However, the pixel device according to this embodiment is distinguished from the pixel device shown in FIG. 20 in that a concave portion is formed under a region corresponding to a connecting portion between the first conductivity type semiconductor layer 311 of the first light emitting structure 310 to the first conductivity type semiconductor layer 331 of the third light emitting structure 330. Accordingly, a height h1 corresponding to the connecting portion between the first conductivity type semiconductor layer 311 of the first light emitting structure 310 and the first conductivity type semiconductor layer 331 of the third light emitting structure 330 is lowered, as compared with the pixel device shown in FIG. 20, and a step is formed under the first conductivity type semiconductor layer 311 of the first light emitting structure 310.

The height h1 of the semiconductor connector, the height h2 of the third molding layer 430 disposed on the semiconductor connector and the height h3 of the third connection layer 373 may satisfy a relation: h1<h3<h2 or h1<h2<h3.

Although FIG. 21 shows the step vertically formed under the first conductivity type semiconductor layer 311 of the first light emitting structure 310, the step may have a slanted side surface having an inclination. Further, the inclination of the side surface of the step formed under the first conductivity type semiconductor layer 311 of the first light emitting structure 310 may be different from an inclination of the outer peripheral region of the light emitting device.

Descriptions of the same components as the exemplary embodiments shown in FIG. 19 and FIG. 20 will be omitted.

Although some exemplary embodiments have been described herein with reference to the accompanying drawings, it should be understood that the foregoing embodiments are provided for illustration only and are not to be in any way construed as limiting the technical idea of the present disclosure. In addition, it should be understood that features or components described with respect to one exemplary embodiment may be applied to other embodiments without departing from the spirit of the present disclosure.

## Claims

1. A pixel device comprising:
a first light emitting structure;
a second light emitting structure disposed under the first light emitting structure;
a third light emitting structure disposed horizontally side-by-side to the first light emitting structure; and
a first molding layer disposed on the third light emitting structure,
wherein the first molding layer converts a wavelength of light emitted from the third light emitting structure.

2. The pixel device according to claim 1, wherein a peak wavelength of light subjected to wavelength conversion by the first molding layer has a full width at half maximum(FWHM) of 50 nm or less.

3. The pixel device according to claim 1, further comprising: a second molding layer disposed on the first light emitting structure.

4. The pixel device according to claim 1, wherein the first light emitting structure and the third light emitting structure emit the same color-based light.

5. The pixel device according to claim 4, wherein the first light emitting structure and the third light emitting structure emit blue-based light and the first molding layer converts light emitted from the third light emitting structure into red-based light through wavelength conversion.

6. The pixel device according to claim 5, wherein light emitted from the first light emitting structure and the third light emitting structure has a peak wavelength in the range of 430 nm to 470 nm.

7. The pixel device according to claim 5, wherein light subjected to wavelength conversion by the first molding layer has a peak wavelength in the range of 600 nm to 680 nm.

8. The pixel device according to claim 1, further comprising:
a first cover layer surrounding exposed side surfaces and lower surfaces of the first light emitting structure, the second light emitting structure, and the third light emitting structure.

9. The pixel device according to claim 1, further comprising:
an ohmic layer disposed on a lower surface of a second conductivity type semiconductor layer of at least one of the first light emitting structure, the second light emitting structure, and the third light emitting structure.

10. The pixel device according to claim 1, further comprising:
multiple electrode pads electrically connected to at least one of the first light emitting structure, the second light emitting structure, and the third light emitting structure.

11. The pixel device according to claim 10, further comprising:
multiple connection layers connected to the multiple electrode pads, respectively.

12. The pixel device according to claim 1, wherein a first conductivity type semiconductor layer of the first light emitting structure is integrally formed with a first conductivity type semiconductor layer of the third light emitting structure.

13. The pixel device according to claim 12, further comprising:
a concave portion formed under a portion corresponding to a connecting portion between the first conductivity type semiconductor layer of the first light emitting structure and the first conductivity type semiconductor layer of the third light emitting structure.

14. The pixel device according to claim 1, further comprising:
a bonding layer bonding the first light emitting structure to the second light emitting structure.

15. A display apparatus comprising:
a circuit substrate; and
the pixel device according to any one of claims 1 to 14 disposed on the circuit substrate.

16. A pixel device comprising:
a first light emitting structure generating a first light having a first full width at half maximum(FWHM);
a second light emitting structure disposed under the first light emitting structure and having a second FWHM;
a third light emitting structure disposed horizontally side-by-side to the first light emitting structure and having a third FWHM; and
a first molding layer disposed on the third light emitting structure,
wherein a light emitted through the first molding layer comprises a fourth FWHM,
the first FWHM being greater than the fourth FWHM.

17. The pixel device according to claim 16, wherein the second FWHM is greater than the first FWHM.

18. The pixel device according to claim 16, wherein the third FWHM is greater than the fourth FWHM.

19. The pixel device according to claim 16, further comprising:
a second molding layer disposed on the first light emitting structure.

20. The pixel device according to claim 16, further comprising:
a bonding layer bonding the first light emitting structure to the second light emitting structure.
